# EUROPEAN PATENT SPECIFICATION

(11) **EP 1 470 597 B1**
(45) Date of publication and mention of the grant of the patent: **03.03.2010**
(21) Application number: 03705904.5
(22) Date of filing: 24.01.2003
(51) Int. Cl.: H01G 9/20

(54) **PHOTOVOLTAIC FIBERS**
PHOTOVOLTAIK-FASERN
FIBRES PHOTOVOLTAIQUES

(30) Priority: 25.01.2002 US 57394; 25.01.2002 US 351691 P; 01.02.2002 US 353138 P; 29.03.2002 US 368832 P; 31.07.2002 US 400289 P
(43) Date of publication of application: 27.10.2004
(60) Divisional application: 08157606.8
(73) Proprietor: Konarka Technologies, Inc., Lowell, MA 01852 (US)
(72) Inventor: CHITTIBABU, Kethinni, Lowell, MA 01851 (US); GAUDIANA, Russell, A., Merrimack, NH 03054 (US); LI, Lian, North Chelmsford, MA 01863 (US); ECKERT, Robert, Lexington, MA 02420 (US); MONTELLO, Alan, W. Newbury, MA 01985 (US); MONTELLO, Edmund, Rockport, MA 01966 (US); WORMSER, Paul, Harvard, MA 01451 (US)
(74) Representative: Peterreins, Frank
(86) International application number: PCT/US2003/002261
(87) International publication number: WO 2003/065471

(56) References cited:
- EP-A- 1 033 762
- WO-A-00/76660
- US-A- 5 474 621
- BAPS B ET AL: "Ceramic based solar cells in fiber form" EURO CERAMICS VII. 7TH CONFERENCE AND EXHIBITION OF THE EUROPEAN CERAMIC SOCIETY, BRUGGE, BELGIUM, 9-13 SEPT. 2001, vol. 206-213, pt.2, pages 937-940, XP008022335 Key Engineering Materials, 2002, Trans Tech Publications, Switzerland ISSN: 1013-9826
- ZOU X ET AL: "Photo-rechargeable battery with TiO2/carbon fiber electrodes prepared by laser deposition" SOLAR ENERGY MATERIALS AND SOLAR CELLS, ELSEVIER SCIENCE PUBLISHERS, AMSTERDAM, NL, vol. 62, no. 1-2, April 2000 (2000-04), pages 133-142, XP004195305 ISSN: 0927-0248

## Description

### Field of the Invention

The invention relates generally to the field of photovoltaic devices, and more specifically to photovoltaic fibers.

### Background of the Invention

Thin film solar cells that are composed of percolating networks of liquid electrolyte and dye-coated sintered titanium dioxide were developed by Dr. Michael Grätzel and coworkers at the Swiss Federal Institute of Technology. These photovoltaic devices fall within a general class of cells referred to as dye sensitized solar cells ("DSSCs"). Conventionally, fabrication of DSSCs requires a high temperature sintering process (> about 400 °C) to achieve sufficient interconnectivity between the nanoparticles and enhanced adhesion between the nanoparticles and a transparent substrate. Although the photovoltaic cells of Grätzel are fabricated from relatively inexpensive raw materials, the high temperature sintering technique used to make these cells limits the cell substrate to rigid transparent materials, such as glass, and consequently limits the manufacturing to a batch process. Furthermore, the rigid substrate precludes the incorporation of these DSSCs into flexible coverings for commercial, industrial, agricultural, and/or military applications.

EP-A-1 033762 discloses a solar collector, comprising hollow or porous fibers supporting a photovoltaic active material. The hollow fibers are internally coated, forming electrode and counter electrode contact layers separated by an absorption layer.

BAPS B ET AL in the article "Ceramic based solar cells in fiber form", EUROCERAMICS VII. 7TH CONFERENCE AND EXHIBITION OF THE EUROPEAN CERAMIC SOCIETY, BRUEGGE, BELGIUM, 9-13 SEPT. 2001, vol. 206-213, pt.2, pages 937-940, XP008022335 Key Engineering Materials, 2002, Trans Tech Publications, Switzerland, discloses a photochemical solar cell in fiber form. A conductive stainless steel internal electrode is coated with semiconductive nanosized TiO2 powder and different organic dyes are used to sensitize the TiO2 powder. The assembly of electrode, ceramic powder and electrolyte is incorporated into a transparent polymer tube that has been coated with conductive polymer on the inside.

Y. Hao et al. describes in "A photoelectrochemical solar cell based on ZnO/dye/polypyrrole film electrode as photoanode", Solar Energy Mat. & Solar Cells 60 (2000) 349 - 359, that a preliminary PEC solar cell was fabricated based on nanostructured ZnO/dye/polypyrrole film electrode. Photoelectrochemical measurements were carried out using a standard three-compartment cell consisting of a Pt wire counter electrode and a saturated calomel electrode (SCE) as a reference.

### Summary of the Invention

The object of the present invention is to facilitate the electrical connection of a photovoltaic fiber, while at the same time still provide for good structural and functional features of the photovoltaic fiber.

This object is achieved according to the present invention by a photovoltaic fiber as defined in claim 1 and a method of forming a photovoltaic fiber as defined in claim 10. Advantageous embodiments are described in the dependent claims.

### Brief Description of the Drawings

The foregoing object and other features, and advantages of the invention described above will be more fully understood from the following description, when read together with the accompanying drawings. In the drawings, like reference characters generally refer to the same parts throughout the different views. The drawings are not necessarily to scale, and emphasis instead is generally placed upon illustrating the principles of the invention.
Figures1A-1D show cross-sectional views of various illustrative examples of a photovoltaic material including an electrically conductive fiber core;
Figures 2A-2D depict cross-sectional views of various illustrative examples of a photovoltaic material including an electrically conductive fiber core and a catalytic media layer;
Figures 3A-3D depict cross-sectional views of various illustrative examples of a photovoltaic material including an electrically insulative fiber core;
Figures 4A-4D show cross-sectional views of various illustrative examples of a photovoltaic material including an electrically insulative fiber core and a catalytic media layer;
Figure 5 depicts a cross-sectional view of one illustrative embodiment of a photovoltaic material including an electrically conductive fiber core and wires imbedded in the electrical conductor, according to the invention;
Figures 6A and 6B depict the formation of a flexible fiber including a photovoltaic cell;
Figure 6C shows a cross-sectional view of an exemplary photovoltaic material formed using the method depicted in Figures 6A and 6B;
Figure 7 shows an exemplary embodiment of a photovoltaic cell in the form of a fiber, according to an illustrative embodiment of the invention;
Figures 8A-8C show various illustrative examples that demonstrate the electrical connection of photovoltaic fibers to form a flexible fabric;
Figure 9 shows an exemplary photovoltaic fabric formed from photovoltaic materials;
Figure 10 depicts an illustrative examples of a two-component photovoltaic mesh;
Figure 11 shows an exemplary method for forming a flexible fiber including a photovoltaic material using a continuous manufacturing process;
Figure 12 depicts an exemplary chemical structure of an illustrative examples of a polylinker for nanoparticles of an oxide of metal M;
Figure 13 depicts another exemplary chemical structure of an illustrative example of a polylinker for nanoparticles of an oxide of metal M;
Figure 14A shows an exemplary chemical structure for an interconnected nanoparticle film with a polylinker;
Figure 14B shows the interconnected nanoparticle film of Figure 14A attached to a substrate oxide layer;
Figure 15 depicts the chemical structure of poly(n-butyl titanate);
Figure 16A shows the chemical structure of a titanium dioxide nanoparticle film interconnected with poly(n-butyl titanate);
Figure 16B shows the interconnected titanium dioxide nanoparticle film of Figure 16A attached to a substrate oxide layer;
Figure 17 depicts the chemical structure of gelation induced by a complexing reaction of Li⁺ ions with complexable poly(4-vinyl pyridine) compounds;
Figure 18 shows the chemical structure of a lithium ion complexing with polyethylene oxide segments;
Figures 19A-19C depict chemical structures for exemplary co-sensitizers;
Figures 20A-20B depict additional exemplary chemical structures of co-sensitizers;
Figure 21 shows a graph of the absorbance of diphenylaminobenzoic acid;
Figure 22 depicts an illustrative example of the coating of a semiconductor primer layer coating; and
Figure 23 depicts a cross-sectional view of an exemplary photovoltaic fiber, according to the invention.

### Description of the Illustrative Examples

### A. Photovoltaic Fibers

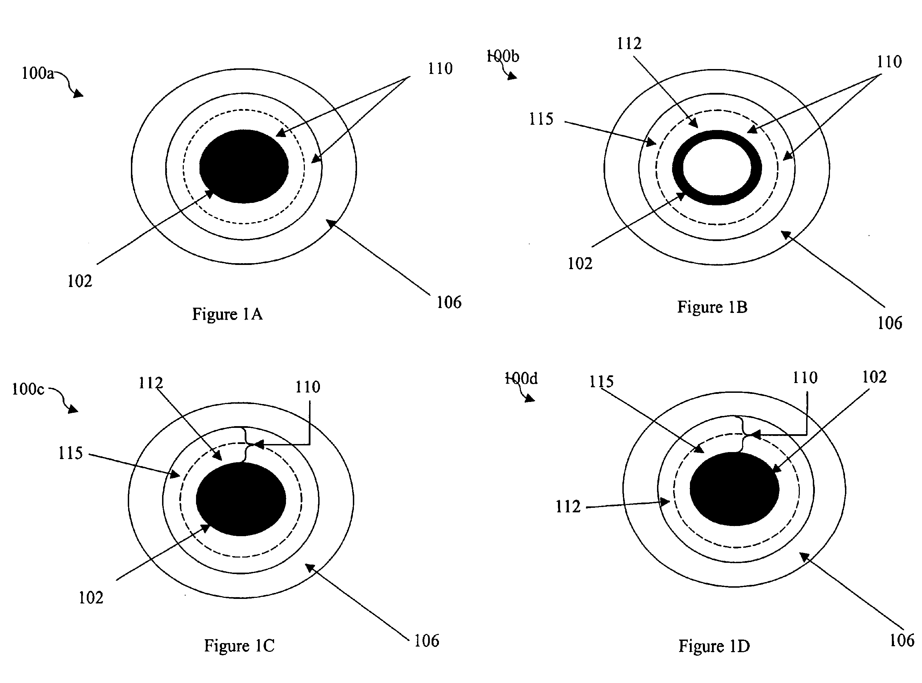

Figures 1A-1D depict various illustrative examples of photovoltaic fibers **100a, 100b, 100c,** and **100d** (collectively "**100**") that each include an electrically conductive fiber core **102,** a significantly light transmitting electrical conductor **106,** and a photoconversion material **110,** which is disposed between the electrically conductive fiber core **102** and the significantly light transmitting electrical conductor **106.** As used herein, the term "significantly light transmitting electrical conductor" refers to an electrical conductor adapted for transmitting at least about 60% of the visible light incident on the conductor in the wavelength region of operation.

The electrically conductive fiber core **102** may take many forms. In the embodiemnt illustrated in Figure 1A, the electrically conductive fiber core **102** is substantially solid. Figure 1B depicts an electrically conductive fiber core **102** that is substantially hollow. According to the illustrative examples of Figures 1C-1D, the photoconversion material **110** includes a photosensitized nanomatrix material **112** and a charge carrier material **115.** The charge carrier material **115** may form a layer, be interspersed with the photosensitized nanomatrix material **112,** or be a combination of both. Referring to Figure 1C, the photosensitized nanomatrix material **112** is adjacent to the electrically conductive fiber core **102.** Referring to Figure 1D, the charge carrier material **115** is adjacent to the electrically conductive fiber core **102.**

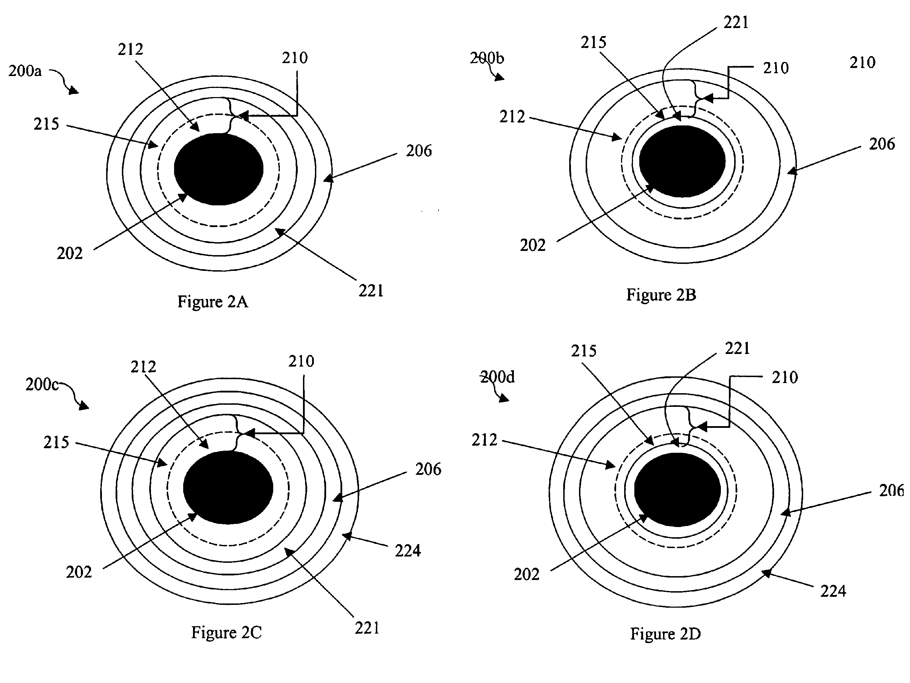

Figures 2A-2D depict various illustrative examples of photovoltaic fibers **200a, 200b, 200c,** and **200d** (collectively "**200**") that each include an electrically conductive fiber core **202,** a significantly light transmitting electrical conductor **206,** and a photoconversion material **210,** which is disposed between the electrically conductive fiber core **202** and the significantly light transmitting electrical conductor **206.** The electrically conductive fiber core **202** may be substantially solid or substantially hollow. According to the illustrative examples of Figures 2A-2D, the photoconversion material **210** includes a photosensitized nanomatrix material **212** and a charge carrier material **215.** The charge carrier material **215** may form a layer, be interspersed with the photosensitized nanomatrix material **212,** or be a combination of both. The photovoltaic fibers **200** also include a catalytic media **221** disposed adjacent to the charge carrier material **215** to facilitate charge transfer or current flow from the significantly light transmitting electrical conductor **206** and the electrically conductive fiber core **202** to the charge carrier material **215.**

The photovoltaic fiber **200a** depicted in Figure 2A shows that the photo-conversion material **210** is disposed between the catalytic media **221** and the electrically conductive fiber core **202.** In this illustrative example, the photosensitized nanomatrix material **212** is adjacent to the electrically conductive fiber core **202.** In the photovoltaic fiber **200b** illustrated in Figure 2B, the catalytic media **221** is disposed between the electrically conductive fiber core **202** and the photoconversion material **210.** In Figure 2C, the photovoltaic fiber **200c** includes the photovoltaic fiber **200a** with a protective layer **224** disposed on at least a portion of the significantly light transmitting electrical conductor **206.** In Figure 2D, the photovoltaic fiber **200d** includes the photovoltaic fiber **200b** with a protective layer **224** disposed on at least a portion of the significantly light transmitting electrical conductor **206.**

Although the electrically conductive fiber cores **102** and **202** and resultant photovoltaic fibers **100** and **200** illustrated in Figures 1 and 2 appear to have substantially circular cross-sections, their cross-sections are not limited to being substantially circular. Other suitable cross-sectional shapes for the electrically conductive fiber cores **102** and **202** and photovoltaic fibers **100** and **200** include, for example, those that are substantially square, rectangular, elliptical, triangular, trapezoidal, polygonal, arcuate, and even irregular shapes. In addition, the electrically conductive fiber cores **102** and **202** may be single-stranded fibers or a multi-stranded fibers (e.g., twisted fibers).

According to the illustrative examples, the electrically conductive fiber cores **102** and **202** may have a wide range of thicknesses. Fiber thickness may be chosen, for example, based on desired strength, flexibility, current carrying capacity, voltage carrying capacity, cost, ease of fabrication into a fabric, and appearance, among other factors. The thicknesses of the electrically conductive fiber cores **102** and **202** may range from that of a microscopic thread (about 100 Å) to that of a human hair (about 125 µm) to that of a rope (about 1 cm). In other illustrative examples, the thicknesses of the electrically conductive fiber cores **102** and **202** are between about 1 µm and about 10 µm. In another class of illustrative examples, the electrically conductive fiber cores **102** and **202** are between about 75 µm and about 1000 µm thick.

Many materials are suitable for use as the electrically conductive fiber core **102** and **202.** These materials include, for example, metals, metal oxides, conductive polymers, and filled polymers. Suitable metals include, but are not limited to, copper, silver, gold, platinum, nickel, palladium, iron, titanium, and alloys thereof. Suitable metal oxides include, but are not limited to, indium tin oxide (ITO), a fluorine-doped tin oxide, tin oxide, zinc oxide, and the like. Suitable conductive polymers include, but are not limited to, polyaniline and polyacetylene doped with arsenic pentaflouride. Filled polymers include, but are not limited to, fullerene-filled polymers and carbon-black-filled polymers.

In various illustrative examples, the photovoltaic fibers **100** and **200** are incorporated into a flexible fabric in a manner further described below. The materials of the electrically conductive fiber cores **102** and **202** may be selected to produce a colored or colorless fiber. Therefore, the colors of the flexible fabric are created by selecting the electrically conductive fiber cores **102** and **202** from a variety of available colors. The electrically conductive fiber cores **102** and **202** may also be transparent, semi-transparent, or opaque. For example, the electrically conductive fiber cores **102** and **202** may be transparent and significantly light transmitting and/or guide light to their respective photoconversion materials **110** and **210.**

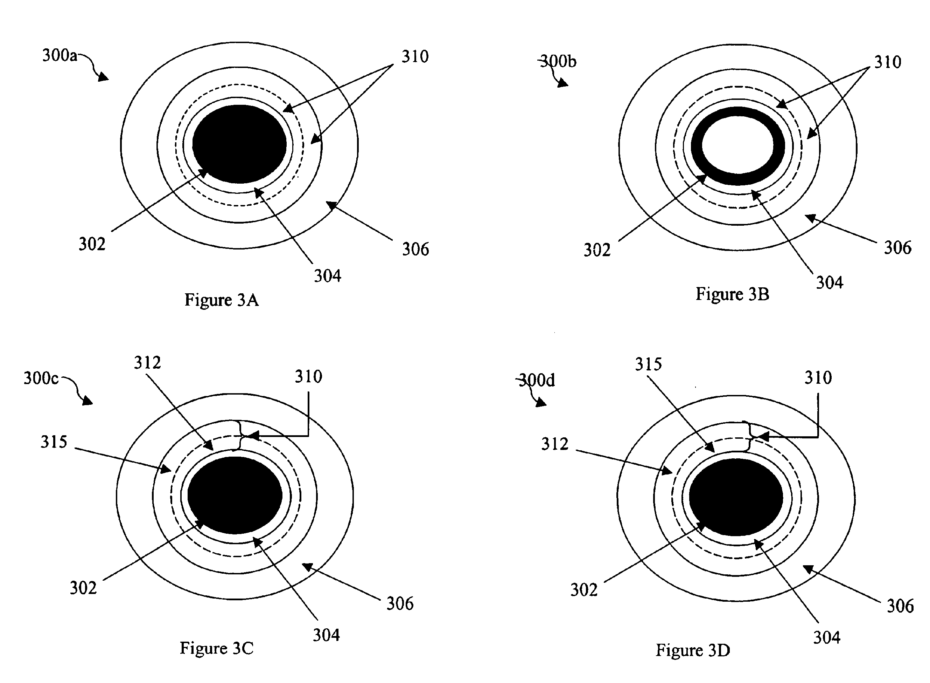

Figures 3A-3D depict various illustrative examples of photovoltaic fibers **300a, 300b, 300c,** and **300d** (collectively "**300**") that each include an electrically insulative fiber core **302,** an inner electrical conductor **304** disposed on the outer surface of the electrically insulative fiber core **302,** a significantly light transmitting electrical conductor **306,** and a photoconversion material **310** disposed between the inner electrical conductor **304** and the significantly light transmitting electrical conductor **306.**

The electrically insulative fiber core **302** may take many forms. In Figure 3A, the electrically insulative fiber core **302** is substantially solid. Figure 3B depicts an electrically insulative fiber core **302** that is substantially hollow. According to the illustrative examples of Figures 3C-3D, the photoconversion material **310** includes a photosensitized nanomatrix material **312** and a charge carrier material **315.** The charge carrier material **315** may form a layer, be interspersed with the photosensitized nanomatrix material **312,** or be a combination of both. Referring to Figure 3C, the photosensitized nanomatrix material **312** is adjacent to the inner electrical conductor **304.** Referring to Figure 3D, the charge carrier material **315** is adjacent to the inner electrical conductor **304.**

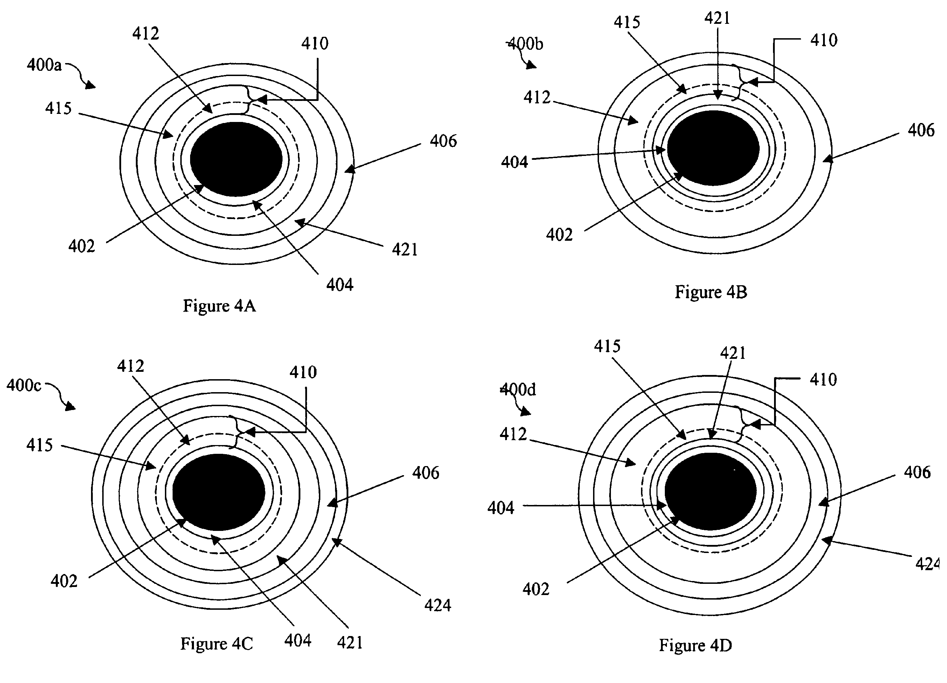

Figures 4A-4D depict various illustrative examples of photovoltaic fibers **400a, 400b, 400c,** and **400d** (collectively "**400**") that each include an electrically insulative fiber core **402,** an inner electrical conductor **404** disposed on the outer surface of the electrically insulative fiber core **402,** a significantly light transmitting electrical conductor **406,** and a photoconversion material **410** disposed between the inner electrical conductor **404** and the significantly light transmitting electrical conductor **406.** The electrically insulative fiber core 402 may be substantially solid or substantially hollow. According to the illustrative examples of Figures 4A-4D, the photo conversion material **410** includes a photosensitized nanomatrix material **412** and a charge carrier material **415.** The charge carrier material **415** may form a layer, be interspersed with the photosensitized nanomatrix material **412,** or be a combination of both. The photovoltaic fibers **400** also include a catalytic media **421** adjacent to the charge carrier material **415** to facilitate charge transfer or current flow from the significantly light transmitting electrical conductor **406** and the electrically insulative fiber core **402** to the charge carrier material **415.**

In the photovoltaic fiber **400a** depicted in Figure 4A, the photoconversion material **410** is disposed between the catalytic media **421** and the inner electrical conductor **404.** In this illustrative examples, the photosensitized nanomatrix material **412** is adjacent to the inner electrical conductor **404.** The photovoltaic fiber **400b** illustrated in Figure 4B depicts that the catalytic media **421** is disposed between the inner electrical conductor **404** and the photoconversion material **410.** In Figure 4C, the photovoltaic fiber **400c** includes the photovoltaic fiber **400a** with a protective layer **424** disposed on at least a portion of the significantly light transmitting electrical conductor **406.** In Figure 4D, the photovoltaic fiber **400d** includes the photovoltaic fiber **400b** with a protective layer **424** disposed on at least a portion of the significantly light transmitting electrical conductor **406.**

Although the electrically insulative fiber cores **302** and **402** and resultant photovoltaic fibers **300** and **400** illustrated in Figures 3 and 4 appear to have substantially circular cross-sections, their cross-sections are not limited to being substantially circular. Other suitable cross-sectional shapes for the electrically insulative fiber cores **302** and **402** and photovoltaic fibers **300** and **400** include, for example, those that are substantially square, rectangular, elliptical, triangular, trapezoidal, polygonal, arcuate, and even irregular shapes. In addition, the electrically insulative fiber cores **302** and **402** may be single-stranded fibers or a multi-stranded fibers (e.g., twisted fibers).

According to the illustrative examples, the electrically insulative fiber cores **302** and **402** may have a wide range of thicknesses. Fiber thickness may be chosen, for example, based on desired strength, flexibility, current carrying capacity, voltage carrying capacity, cost, ease of fabrication into a fabric, and appearance, among other factors. The thicknesses of the electrically insulative fiber cores **302** and **402** may range from that of a microscopic thread (about 100 Å) to that of a human hair (about 125 µm) to that of a rope (about 1 cm). In other illustrative examples, the thicknesses of the electrically insulative fiber cores **302** and **402** are between about 1 µm and about 10 µm. In another class of illustrative examples, the electrically insulative fiber cores **302** and **402** are between about 75 µm and about 1000 µm thick.

Many materials are suitable for use as the electrically insulative fiber cores **302** and **402.** These materials include, for example, glass, traditional textile fibers, and insulative polymers and plastics. Suitable traditional textile fibers include, but are not limited to, flax, cotton, wool, silk, nylon, and combinations thereof. Suitable insulative polymers and plastics include, but are not limited to, polyaramides (e.g., the KEVLAR material available from DuPont), nylons, polyethylene terephthalate (PET), polyimide, polyethylene naphthalate (PEN), polymeric hydrocarbons, cellulosics, or combinations thereof.

In various illustrative examples, the photovoltaic fibers **300** and **400** are incorporated into a flexible fabric in a manner described in more detail below. The materials of the electrically insulative fiber cores **302** and **402** may be selected to produce a colored or colorless fiber. Therefore, the colors of the flexible fabric are created by selecting the electrically insulative fiber cores **302** and **402** from a variety of available colors. The electrically insulative fiber cores **302** and **402** may also be transparent, semi-transparent, or opaque. For example, the electrically insulative fiber cores **302** and **402** may be transparent and significantly light transmitting and/or guide light to their respective photoconversion materials **310** and **410.**

The inner electrical conductors **304** and **404** may include any suitable conductive material. In various illustrative examples, the inner electrical conductors **304** and **404** are significantly light transmitting. Suitable materials for the inner electrical conductors **304** and **404** include, but are not limited to, copper, silver, gold, platinum, nickel, palladium, iron, alloys thereof, ITO, and conductive polymers such as polyaniline and aniline. In various illustrative examples, the inner electrical conductors **304** and **404** are between about 0.5 µm and about 5 µm thick. Preferably, the inner electrical conductors **304** and **404** are between about 0.5 µm and about 1 µm thick.

In various illustrative examples, the photovoltaic fibers **100, 200, 300** and **400** include the electrically conductive fiber cores **102** and **202** or the electrically insulative fiber cores **302** and **402** with glass transition temperatures in the range between about 10 °C and about 300 °C. For example, one suitable material for the electrically insulative fiber cores **302** and **402** is PET, which has a glass transition temperature of about 45°C. However, it should be recognized that not all materials suitable for the photovoltaic fibers **100, 200, 300** and **400** have a glass transition temperature. For those materials, the significant temperature is (1) the degree at which the interconnection of the materials forming the photoconversion materials **110, 210, 310** and **410** is disrupted and/or (2) the degree at which the electrical connection between the photoconversion materials **110, 210, 310** and **410** and (i) the electrically conductive fiber cores **102** and **202,** (ii) the inner electrical conductors **304** and **404,** and/or (iii) the significantly light transmitting electrical conductors **106, 206, 306** and **406** is disrupted.

Referring to the illustrative examples shown in Figures 1-4, the significantly light transmitting electrical conductors **106, 206, 306** and **406** include transparent materials, such as, for example, ITO, a fluorine-doped tin oxide, tin oxide, zinc oxide, and the like. The significantly light transmitting electrical conductors **106, 206, 306** and **406** may be colored or colorless. Preferably, the significantly light transmitting electrical conductors **106, 206, 306** and **406** are clear and transparent. Moreover, the significantly light transmitting electrical conductors **106, 206, 306** and **406** are preferably formed on their respective photoconversion materials **110, 210, 310** and **410,** such that the resultant photovoltaic fibers **100, 200, 300** and **400** are flexible. In various illustrative examples, the significantly light transmitting electrical conductors **106, 206, 306** and **406** are less than about 1 µm thick. The significantly light transmitting electrical conductors **106, 206, 306** and **406** may range from between about 100 nm to about 500 nm thick. In other illustrative examples, the significantly light transmitting electrical conductors **106, 206, 306** and **406** are between about 150 nm and about 300 nm thick.

In various illustrative examples, the photoconversion materials **110, 210,310** and **410** are between about 1 µm and about 5 µm thick. In other illustrative examples, the photoconversion material **110, 210, 310** and **410** are between about 5 µm and about 20 µm thick. In various illustrative examples, the photoconversion materials **110** and **310** include a heterojunction composite material. Suitable heterojunction composite materials include fullerenes (e.g., C₆₀), fullerene particles, or carbon nanotubes. The heterojunction composite material may be dispersed in polythiophene or some other hole transport material. In various illustrative examples, the heterojunction composite material includes individual fullerenes and/or fullerene particles that have an average size of between about 14 nm and about 500 nm. Other examples of suitable heterojunction composite materials are composites including conjugated polymers, such as polythiophene and polyquinoline, and composites of conjugated polymers, such as polyphenylene vinylene, in conjunction with non-polymeric materials.

In various illustrative examples, long-range order is not required of the photosensitized nanomatrix materials **112, 212, 312** and **412.** For example, the photosensitized nanomatrix materials **112, 212, 312** and **412** need not be crystalline, nor must the particles or phase regions be arranged in a regular, repeating, or periodic array. In various illustrative examples, the nanomatrix materials **112, 212, 312** and **412** may be between about 0.5 µm and about 20 µm thick.

In various illustrative examples, the photosensitized nanomatrix materials **112, 212, 312** and **412** are photosensitized by a photosensitizing agent. The photosensitizing agent facilitates conversion of incident visible light into electricity to produce the desired photovoltaic effect. It is believed that the photosensitizing agent absorbs incident light resulting in the excitation of electrons in the photosensitizing agent. The energy of the excited electrons is then transferred from the excitation levels of the photosensitizing agent into a conduction band of the photosensitized nanomatrix material **112, 212, 312** or **412.** This electron transfer results in an effective separation of charge and the desired photovoltaic effect. Accordingly, the electrons in the conduction bands of the nanomatrix materials **112, 212, 312** and **412** are made available to drive an external load, which may be electrically connected to the photovoltaic fibers **100, 200, 300** and **400.**

The photosensitizing agent may be sorbed (either chemisorbed and/or physisorbed) on the photosensitized nanomatrix material **112, 212, 312,** and **412.** The photosensitizing agent may be sorbed on a surface of the photosensitized nanomatrix material **112, 212, 312** and **412,** throughout the photosensitized nanomatrix material **112, 212, 312** and **412,** or both. The photosensitizing agent is selected based on, for example, its ability to absorb photons in the wavelength region of operation, its ability to produce free electrons (or holes) in the conduction bands of the photosensitized nanomatrix materials **112, 212, 312** and **412,** and its effectiveness in complexing with or sorbing to the photosensitized nanomatrix materials **112, 212, 312** and **412.** Suitable photosensitizing agents may include, for example, dyes having functional groups, such as carboxyl and/or hydroxyl groups, that can chelate to the nanoparticles. Examples of suitable dyes include, but are not limited to, porphyrins, phthalocyanines, merocyanines, cyanines, squarates, eosins, xanthines, pyrroles, and metal-containing, such as *cis-*bis(isothiocyanato)bis(2,2'-bipyridyl-4,4'-dicarboxylato)-ruthenium(II) ("N3 dye"); tris(isothiocyanato)-ruthenium(II)-2,2':6',2"-terpyridine-4,4',4"- tricarboxylic acid; *cis-*bis(isothiocyanato)bis(2,2'-bipyridyl-4,4'-dicarboxylato)-ruthenium(II) bis-tetrabutyl ammonium; cis-bis(isocyanato) (2,2'-bipyridyl-4,4' dicarboxylato) ruthenium(II); and tris(2,2'-bipyridyl-4,4'-dicarboxylato) ruthenium (II) dichloride, all of which are available from Solaronix.

Preferably, the photosensitized nanomatrix materials **112, 212, 312** and **412** include one or more types of interconnected metal oxide nanoparticles. Suitable nanoparticle materials include, but are not limited to, the oxides, sulfides, selenides, and tellurides of titanium, zirconium, zinc, lanthanum, niobium, strontium, tantalum, tin, terbium, and tungsten, or one or more combinations thereof. For example, TiO₂, SrTiO₃, CaTiO₃, ZrO₂, WO₃, La₂O₃, Nb₂O₅, sodium titanate, and potassium niobate are suitable nanoparticle materials. In various illustrative examples, the photosensitized nanomatrix materials **112, 212, 312** and **412** include nanoparticles with an average size between about 2 nm and about 100 nm. In other illustrative examples, the photosensitized nanomatrix materials **112, 212, 312** and **412** include nanoparticles with an average size between about 10 nm and about 40 nm. Preferably, the nanoparticles are titanium dioxide particles with an average particle size of about 20 nm.

The charge carrier material **115, 215, 315** and **415** portions of the photoconversion materials **110, 210, 310** and **410** may be any material that facilitates the transfer of electrical charge from a ground potential or a current source to its respective photosensitized nanomatrix material **112, 212, 312** or **412** (and/or a photosensitizing agent of the photosensitized nanomatrix materials **112, 212, 312** and **412**). A general class of suitable charge carrier materials **115, 215, 315** and **415** may include, but are not limited to, solvent-based liquid electrolytes, polyelectrolytes, polymeric electrolytes, solid electrolytes n-type and p-type conducting polymers, and gel electrolytes. Generally, the charge carrier materials **115, 215, 315** and **415** are between about 2 µm and about 20 µm thick.

In various illustrative examples, the charge carrier materials **115, 215, 315** and **415** may include a redox system. Suitable redox systems include, for example, organic and/or inorganic redox systems. More particularly, the redox system may be, for example, cerium(III) sulfate/cerium(IV), sodium bromide/bromine, lithium iodide/iodine, Fe²⁺/Fe³+, Co²⁺/Co³⁺, and/or viologens.

The charge carrier materials **115, 215, 315** and **415** also may include a polymeric electrolyte. In various illustrative examples, the polymeric electrolyte includes poly(vinyl imidazolium halide) and/or poly(vinyl pyridinium salts). In other illustrative examples, the charge carrier materials **115, 215, 315** and **415** include a solid electrolyte. The solid electrolyte may include lithium iodide, pyridinium iodide, and/or substituted imidazolium iodide.

According to various illustrative examples, the charge carrier materials **115, 215, 315** and **415** may include a polymeric polyelectrolyte. The polyelectrolyte may include between about 5% and about 100% (e.g., 5-60%, 5-40%, or 5-20%) by weight of a polymer, e.g., an ion-conducting polymer; about 5% to about 95%, e.g., about 35-95%, 60-95%, or 80-95%, by weight of a plasticizer; and about 0.05 M to about 10 M of a redox electrolyte, e.g., about 0.05 M to about 10 M, e.g., 0.05-2 M, 0.05-1 M, or 0.05-0.5 M, of organic or inorganic iodides, and about 0.01 M to about 1 M, e.g., 0.05-5 M, 0.05-2 M, or 0.05-1 M, of iodine. The ion-conducting polymer may include, for example, polyethylene oxide (PEO), polyacrylonitrile (PAN), polymethylmethacrylate (acrylic) (PMMA), polyethers, and polyphenols. Examples of suitable plasticizers include, but are not limited to, ethyl carbonate, propylene carbonate, mixtures of carbonates, organic phosphates, and dialkylphthalates.

In various illustrative examples, the catalytic media **221** and **421** are in electrical contact with their respective charge carrier materials **215** and **415.** The catalytic media **221** and **421** may include, for example, ruthenium, osmium, cobalt, rhodium, iridium, nickel, palladium or platinum. Preferably, the catalytic media **221** and **421** also include titanium, or another suitable metal, to facilitate adhesion of the catalytic media to the significantly light transmitting electrical conductors **206** and **406,** the electrically conductive fiber core **202,** or the inner electrical conductor **404** disposed on the electrically insulative fiber core **402.** Preferably, the titanium is deposited in regions and as a layer about 10 Å thick. In various illustrative examples, the catalytic media **221** and **421** include a platinum layer between about 13 Å and about 35 Å thick. In other illustrative examples, the catalytic media **221** and **421** include a platinum layer between about 15 Å and about 50 Å thick. In still other illustrative examples, the catalytic media **221** and **421** include a platinum layer between about 50 Å and about 800 Å thick. Preferably, the catalytic media **221** and **421** are a platinum layer about 25 Å thick.

In various illustrative examples, the protective layers **224** and **424** include any suitably light transmitting material. Suitable materials for the protective layers **224** and **424** include, but are not limited to, mylar polyacrylates, polystyrenes, polyureas, polyurethane, epoxies, and the like. Preferably, the protective layers **224** and **424** have thicknesses greater than about 1 µm.

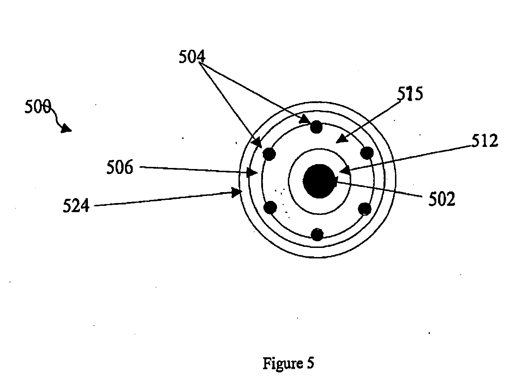

In an examplary embodiment of the invention, Figure 5 depicts a photovoltaic material **500** that includes a fiber **502,** one or more wires 504 that are imbedded in a significantly light transmitting electrical conductor **506,** a photosensitized nanomatrix material **512,** a charge carrier material **515,** and a protective layer **524**. The wires **504** may also be partially imbedded in the charge carrier material **515** to, for example, facilitate electrical connection of the photovoltaic material **500** to an external load, to reinforce the significantly light transmitting electrical conductor **506,** and/or to sustain the flexibility of the photovoltaic material **500.** Preferably, the wire **504** is an electrical conductor and, in particular, a metal electrical conductor. Suitable wire **504** materials include, but are not limited to, copper, silver, gold, platinum, nickel, palladium, iron, and alloys thereof. In one illustrative embodiment, the wire **504** is between about 0.5 µm and about 100 µm thick. In another illustrative embodiment, the wire **504** is between about 1 µm and about 10 µm thick.

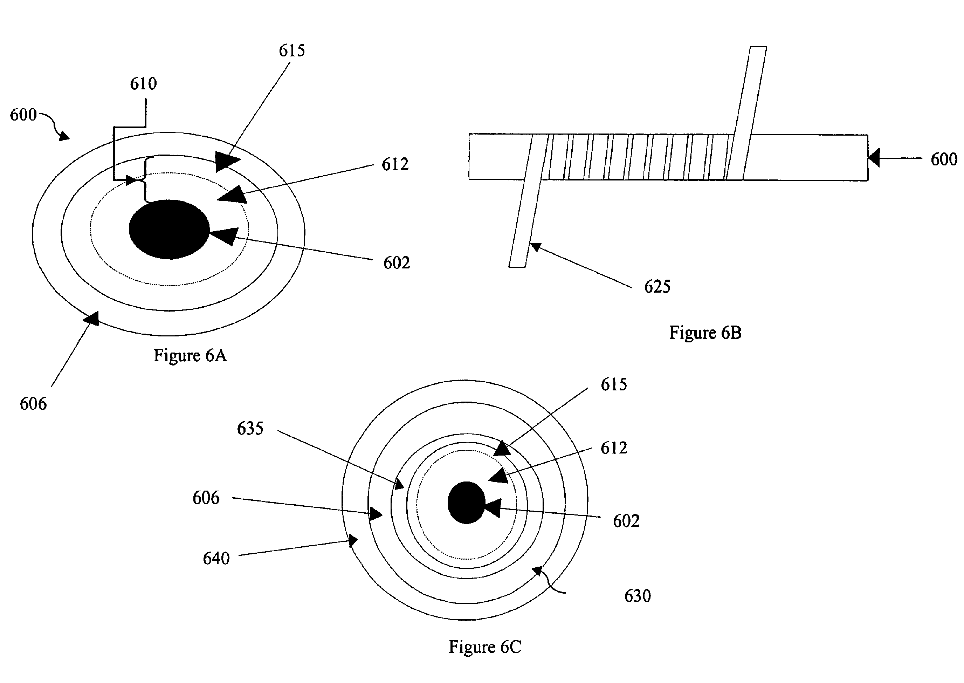

Figures 6A and 6B show a method of forming a photovoltaic material **600** that has an electrically conductive fiber core **602,** a significantly light transmitting electrical conductor **606,** and a photoconversion material **610,** which is disposed between the electrically conductive fiber core **602** and the significantly light transmitting electrical conductor **606.** According to the method, the outer surface of the conductive fiber core **602** is coated with titanium dioxide nanoparticles. The nanoparticles are then interconnected by, for example, sintering, or preferably by contacting the nanoparticles with a reactive polymeric linking agent such as, for example, poly(n-butyl titanate), which is described in more detail below. The interconnected titanium dioxide nanoparticles are then contacted with a photosensitizing agent, such as, for example, a 3x10⁻⁴ M N3-dye solution for 1 hour, to form a photosensitized nanomatrix material **612.** A charge carrier material **615** that includes a gelled electrolyte is then coated on the photosensitized nanomatrix material **612** to complete the photoconversion material **610.**

Referring to Figure 6B, a strip **625** of transparent polymer from about 2.5 µm to about 6 µm thick, coated with a layer of ITO that in turn has been platinized, is wrapped in a helical pattern about the photovoltaic material **600** with the platinized side of the strip **625** in contact with the charge carrier material **615.** In this illustrative example, the strip **625** of transparent polymer is the significantly light transmitting electrical conductor **606.** In other illustrative examples, the significantly light transmitting electrical conductor **606** is formed using the materials described above with regard to Figures 1-4.

Figure 6C shows a cross-sectional view of an illustrative example of a completed photovoltaic material **630** that has a photoconversion material **610** disposed between the conductive fiber core **602** and the significantly light transmitting electrical conductor **606.** The photovoltaic material **630** also includes a catalytic media **635** in contact with the charge carrier material **615** and a protective transparent polymer layer **640** disposed on the significantly light transmitting electrical conductor **606.**

In another example of the method illustrated in Figures 6A and 6B, the electrically conductive fiber core **602** is replaced with an electrically insulative fiber core that has been coated with a layer of platinum to form an inner electrical conductor. The subsequent formation of a photoconversion material **610** and helical wrapping with strip **625** then proceeds as described above to form the photovoltaic material.

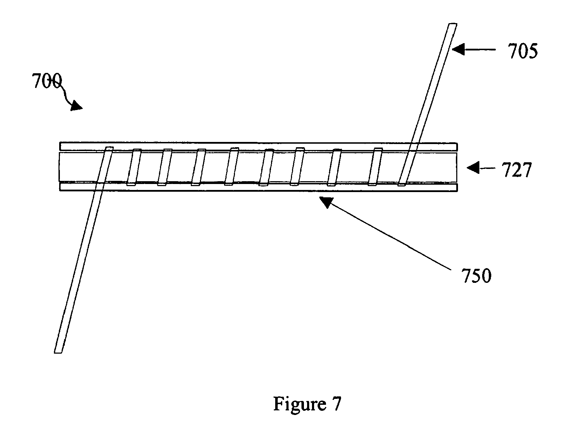

Referring to Figure 7, in another illustrative embodiment, a photovoltaic material 700 is formed by wrapping a platinum or platinized wire **705** around a core **727** including a photoconversion material disposed on either an electrically conductive fiber core or on an inner electrical conductor in turn disposed on an insulative fiber core. A strip **750** of transparent polymer coated with a layer of ITO, which has been platinized, is wrapped in a helical pattern about the core **727** with the platinized side of the strip **750** in contact with the wire **705** and the charge carrier material of the core 727.

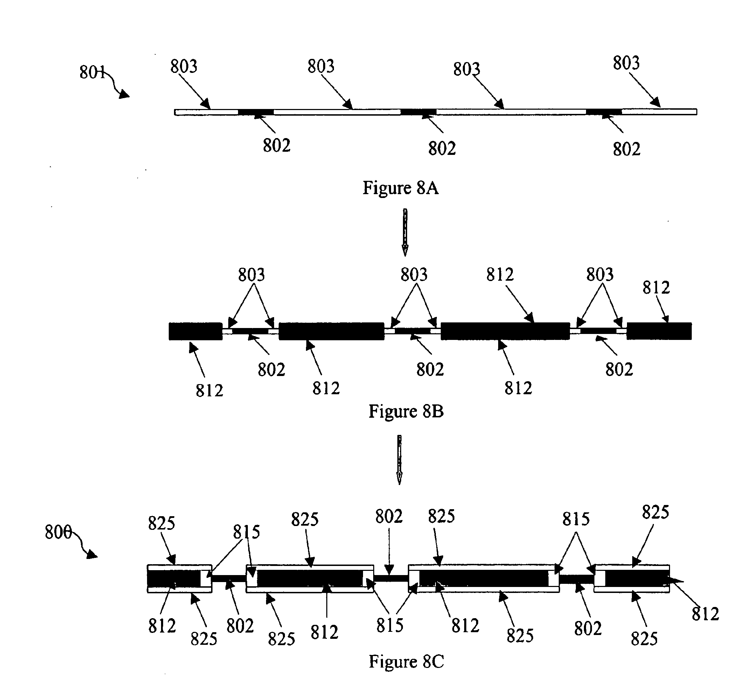

Figures 8A-8C depict another example of a photovoltaic material **800**. The photovoltaic material **800** includes a metal-textile fiber **801,** which has metallic electrically conductive portions **802** and textile portions **803.** The textile portions **803** may be electrically conductive or may be insulative and coated with an electrical conductor. Referring to Figure 8B, a dispersion of titanium dioxide nanoparticles is coated on the outer surface of portions of the textile portions **803** of the metal-textile fiber 801. The particles are then interconnected preferably by contacting the nanoparticles with a reactive polymeric linking agent such as poly(n-butyl titanate), which is further described below. The interconnected titanium dioxide nanoparticles are then contacted with a photosensitizing agent, such as a N3 dye solution, for 1 hour to form a photosensitized nanomatrix material **812**.

Referring to Figure 8C, a charge carrier material **815** including a solid electrolyte is then coated on the textile portions **803.** A strip **825** of PET coated with ITO, that in turn has been platinized, is disposed on the photosensitized nanomatrix material **812** and the charge carrier material **815.** The platinized ITO is in contact with the charge carrier material **815.**

As indicated above, the photovoltaic fibers **100, 200, 300,** and **400** may be utilized to form a photovoltaic fabric. The resultant photovoltaic fabric may be a flexible, semi-rigid, or rigid fabric. The rigidity of the photovoltaic fabric may be selected, for example, by varying the tightness of the weave, the thickness of the strands of the photovoltaic materials used, and/or the rigidity of the photovoltaic materials used. The photovoltaic materials may be, for example, woven with or without other materials to form the photovoltaic fabric. In addition, strands of the photovoltaic material, may be welded together to form a fabric.

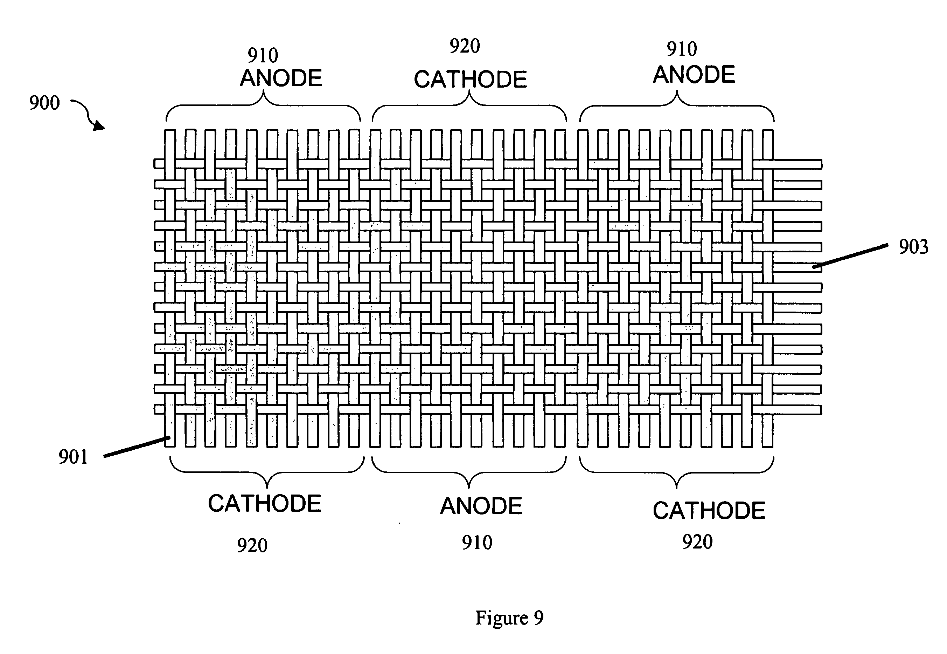

Figure 9 depicts one illustrative example of a photovoltaic fabric **900** that includes photovoltaic fibers **901**. As illustrated, the photovoltaic fabric **900** also includes non-photovoltaic fibers **903.** In various illustrative examples, the non-photovoltaic fibers **903** may be replaced with photovoltaic fibers. Figure 9 also illustrates anodes **910** and cathodes **920** that are formed on the photovoltaic fabric **900** and that may be connected to an external load to form an electrical circuit. The anodes **910** may be formed by a conductive fiber core or an electrical conductor on an insulative fiber core, and the cathodes **920** may be formed by significantly light transmitting electrical conductors. In Figure 9, each edge of the photovoltaic fabric **900** is constructed in an alternating fashion with the anodes **910** and cathodes **920** formed from photovoltaic fibers **901.** In another illustrative example, each edge of photovoltaic fabric **900** is constructed from just one anode or just one cathode, both of which are formed from either photovoltaic fibers, non-photovoltaic fibers, or a combination of both.

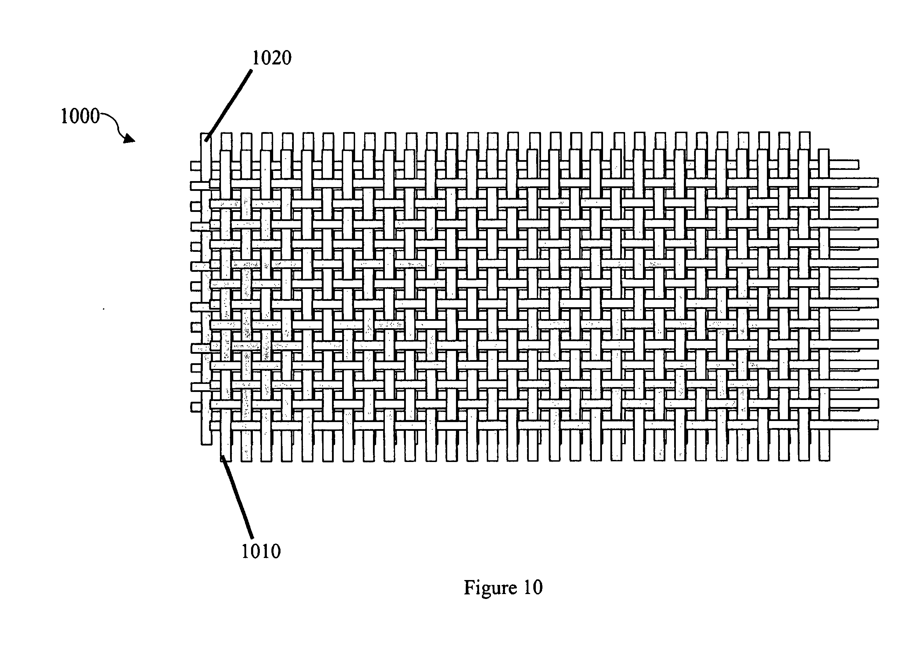

Figure 10 shows a photovoltaic fabric **1000** formed by a two-component photovoltaic material. According to the illustrative example, each component is formed by a mesh, where one mesh serves as the anode **1010** and the other as the cathode **1020.** Each mesh (or component) is connected to a different busbar, which in turn may be connected to opposite terminals of an external load. Hence, a single large-area, fabric-like photovoltaic cell is produced.

According to the illustrated example, the mesh material may be any material suitable as a fiber material. For example, the mesh material may include electrically conductive fiber cores, electrically insulative fiber cores coated with an electrical conductor, or a combination of both. In one example, the anode mesh is made of a metal fiber with a redox potential approximately equal to that of ITO. In another example, the mesh is composed of a plastic fiber, e.g., nylon that is metalized by for example, vacuum deposition or electroless deposition.

In one illustrative example, the anode **1010** mesh of the photovoltaic fabric **1000** is formed by coating the mesh with a dispersion of titanium dioxide nanoparticles by, for example, dripping or slot coating in a suspension. The titanium dioxide nanoparticles are interconnected, for example, by a sintering, or preferably by a reactive polymeric linking agent, such as poly(n-butyl titanate) described in more detail below. After coating with the titania suspension, but prior to either sintering or crosslinking, an air curtain can be used to remove excess titania from the spaces between the fibers of the mesh. Likewise, this, or some other functionally equivalent method, may be used to clear these spaces of excess material after each of the subsequent steps in the preparation of the final photovoltaic fabric. Subsequently, the mesh is slot coated or dipped in a photosensitizing agent solution, such as N3 dye, followed by washing and drying. A charge carrier including a solid electrolyte (e.g., a thermally-reversible polyelectrolyte) is applied to the mesh to from the anode **1010** mesh. In another illustrative example, the cathode **1020** mesh of the photovoltaic fabric **1000** is formed as a platinum-coated mesh, such as, for example, a platinum-coated conductive fiber core mesh or a platinum-coated plastic mesh.

To form the photovoltaic fabric **1000,** the anode **1010** mesh and cathode **1020** mesh are brought into electrical contact and aligned one over the other, so that the strands of each mesh are substantially parallel to one another. Perfect alignment is not critical. In fact, it may be advantageous from the standpoint of photon harvesting to slightly misalign the two meshes. The photovoltaic fabric **1000** may be coated with a solution of a polymer that serves as a protective, transparent, flexible layer.

One of the advantages of the photovoltaic fabric **1000** is its relative ease of construction and the ease with which the anode **1010** and cathode **1020** may be connected to an external circuit. For example, the edges of each mesh, one edge, multiple edges, or all edges may be left uncoated when the coating operations described above are performed. The anode **1010** and cathode **1020** are each electrically connected to its own metal busbar. An advantage of this illustrative example is the elimination of the possibility that severing one wire would disable the entire photovoltaic fabric.

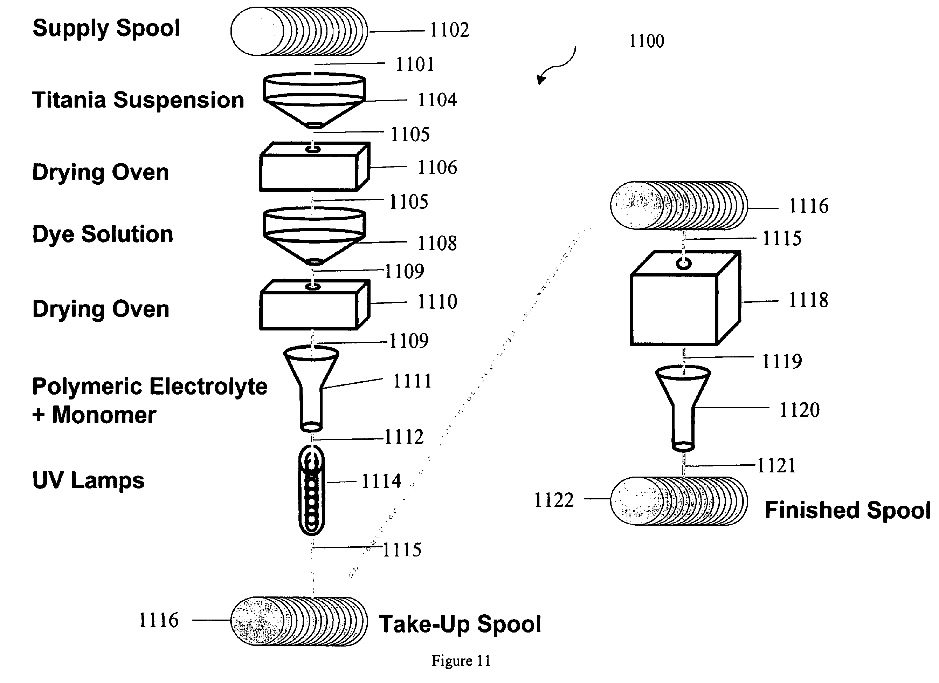

Figure 11 shows a method **1100** for forming a photovoltaic material in the form of a fiber using a continuous manufacturing process. Referring to Figure 11, a fiber **1101** is provided, for example, by a supply spool **1102**. The fiber **1101** may be an electrically insulative fiber core coated with an electrical conductor, an electrically conductive fiber core, or a combination of both. According to the illustrative example, the fiber **1101** is coated with a suspension of titanium dioxide nanoparticles and poly(n-butyl titanate) (serving as a reactive polymeric linking agent) by passing it into such a fluid suspension contained in a cup **1104** with a small hole in its bottom. Upon exiting the cup **1104,** the interconnected nanoparticle-coated fiber **1105** enters an oven **1106** to remove excess suspending medium (e.g., water or other solvent). The interconnected nanoparticle-coated fiber **1105** enters a dye bath **1108** to photosensitize the interconnected nanoparticles. The photosensitized nanoparticle-coated fiber **1109** thereupon enters a drying oven **1110** and/or a wash bath to remove excess solvent.

Next, the photosensitized nanoparticle-coated fiber **1109** passes through a solution **1111** that includes an electrolyte, preferably, a solid state, polymeric electrolyte. The solvent for this polymer solution **1111** may be a non-reactive solvent, in which case it can be removed by heating in a subsequent step, or it may be a reactive solvent such as a monomer. If the solvent for the polyelectrolyte is a monomer, it is preferably chosen such that it can be photopolymerized and such that the resulting polymer structure does not detract from the electrical properties of the polyelectrolyte. Hence, in the illustrative example, where the solvent includes a monomer, the photoconversion material-coated fiber **1112** is passed through a chamber containing UV lamps **1114,** which initiate photopolymerization of the monomer. The resultant fiber **1115** is then coated with the photo conversion material including a solid state electrolyte, and may be readily spooled onto a take-up spool **1116.**

The photoconversion material-coated fiber **1115** then passes through or is placed in a vacuum chamber **1118** where a very thin layer of platinum, followed by a transparent, conductive coating of ITO, are deposited on the fiber. The platinum may be, for example, between about 15 Å and about 50 Å thick. The ITO serves as the significant light transmitting electrical conductor. The completed photovoltaic fiber **1119** may then be passed through a polymer solution **1120** to provide a transparent, protective coating, such as by wire extrusion or other means known to the art. Thus a flexible photovoltaic material **1121** is taken up on a finished spool **1122** and is ready for subsequent use, for example, in a weaving or matting operation.

### B. Low temperature interconnection of nanoparticles

As briefly discussed above, methods of forming a layer of interconnected nanoparticles on a fiber or an electrical conductor disposed on a fiber at temperatures significantly lower than 400 °C are disclosed. In one illustrative example, a polymeric linking agent (hereinafter a "polylinker") enables the fabrication of photovoltaic fibers at relatively low "sintering" temperatures (< about 300 °C). Although the term "sintering" conventionally refers to high temperature (> about 400 °C) processes, as used herein, the term "sintering" is not temperature specific, but instead refers generally to the process of interconnecting nanoparticles at any temperature.

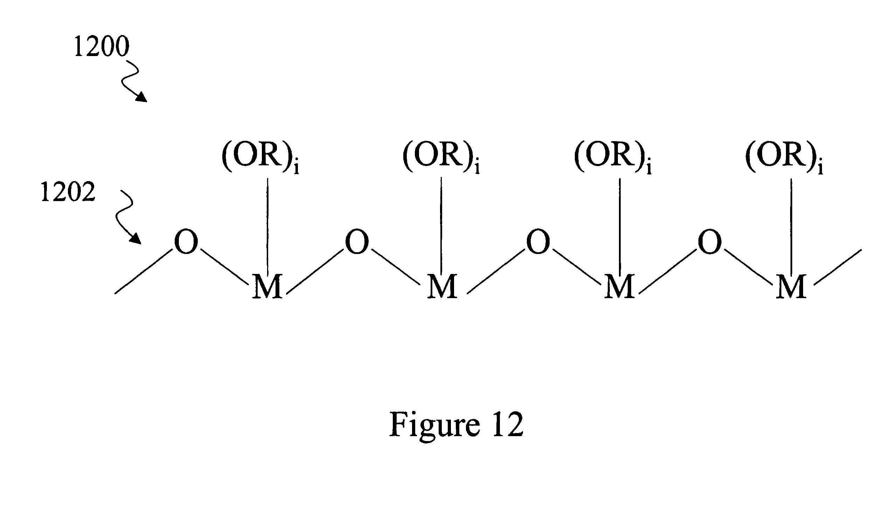

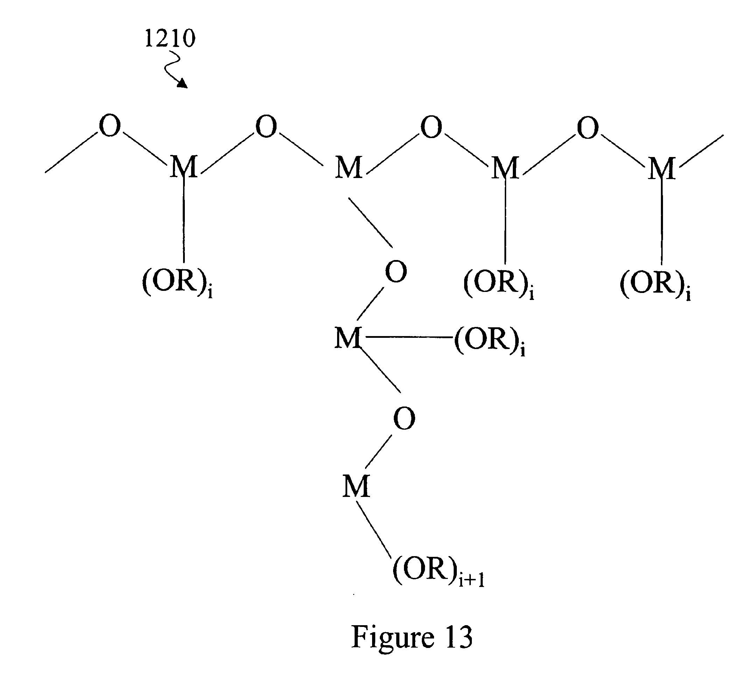

Figures 12 and 13 schematically depict chemical structures of illustrative polylinkers. The particular polylinker structures depicted are for use with nanoparticles of the formula MₓO_{y}, where M may be, for example, titanium (Ti), zirconium (Zr), tungsten (W), niobium (Nb), lanthanum (La), tantalum (Ta), terbium (Tb), or tin (Sn) and x and y are integers greater than zero. According to the illustrative example of Figure 12, the polylinker **1200** includes a backbone structure **1202,** which is similar in structure to the metal oxide nanoparticles, and (OR)ᵢ reactive groups, where R may be, for example, acetate, an alkyl, alkene, alkyne, aromatic, or acyl group; or a hydrogen atom and i is an integer greater than zero. Suitable alkyl groups include, but are not limited to, ethyl, propyl, butyl, and pentyl groups. Suitable alkenes include, but are not limited to, ethene, propene, butene, and pentene. Suitable alkynes include, but are not limited to, ethyne, propyne, butyne, and pentyne. Suitable aromatic group include, but are not limited to, phenyl, benzyl, and phenol. Suitable acyl groups include, but are not limited to, acetyl and benzoyl. In addition, a halogen including, for example, chlorine, bromine, and iodine may be substituted for the (OR)ᵢ reactive groups.

Referring to Figure 13, the polylinker **1210** has a branched backbone structure that includes two -M-O-M-O-M-O- backbone structures, which include (OR)ᵢ reactive groups and (OR)ᵢ₊ᵢ reactive groups, where R may be, for example, one of the atoms, molecules, or compounds listed above and i is an integer greater than zero. The two backbone structures have similar structures to the metal oxide nanoparticles. Collectively, the structure depicted in Figure 13 can be represented by -M(OR)ᵢ-O-(M(OR)ᵢ -O)ₙ-M(OR)ᵢ₊₁, where i and n are integers greater than zero.

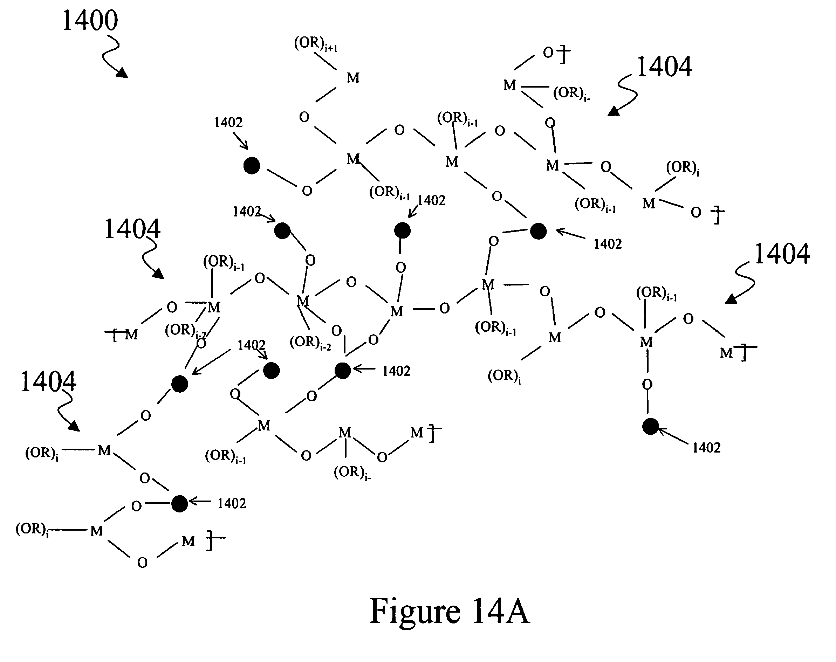

Figure 14A depicts schematically the chemical structure **1400** resulting from interconnecting the MₓO_{y} nanoparticles **1402** with a polylinker **1404.** In various examples, the polylinker **1404** has the chemical structure of the polylinkers 1200 and **1210** depicted in Figures 12 and 13, respectively. According to the illustrative example, the nanoparticles **1402** are interconnected by contacting the nanoparticles **1402** with a polylinker **1404** at or below room temperature or at elevated temperatures that are less than about 300 °C. Preferably, the polylinker **1404** is dispersed in a solvent to facilitate contact with the nanoparticles **1402.** Suitable solvents include, but are not limited to, various alcohols, chlorohydrocarbons (e.g., chloroform), ketones, cyclic and linear chain ether derivatives, and aromatic solvents among others. It is believed that the reaction between surface hydroxyl groups of the nanoparticles **1402** with alkoxy groups on the polymer chain of the polylinker **1404** leads to bridging (or linking) the many nanoparticles **1402** together through highly stable covalent links, and as a result, to interconnecting the nanoparticles **1402.** It also is believed that since the polylinker **1404** is a polymeric material with a chemical structure similar to that of the nanoparticles **1402,** even a few binding (or linking) sites between the nanoparticles **1402** and the polylinker **1404** leads to a highly interconnected nanoparticle film with a combination of electrical and mechanical properties superior to those of a non-sintered or non-interconnected nanoparticle film. The electrical properties include, for example, electron and/or hole conducting properties that facilitate the transfer of electrons or holes from one nanoparticle to another through, for example, π-conjugation. The mechanical properties include, for example, improved flexibility.

Still referring to Figure 14A, at low concentrations of the polylinker **1404,** a single polylinker **1404** polymer can link many nanoparticles **1402** forming a cross-linked nanoparticle network. However, by increasing the concentration of the polylinker **1404** polymer, more polylinker **1404** molecules may be attached to the surface of the nanoparticles **1402** forming polymer-coated nanoparticles **1400.** Such polymer-coated nanoparticles **1400** may be processed as thin films due to the flexibility of the polymer. It is believed that the electronic properties of the polymer-coated nanoparticles are not affected to a significant extent due to the similar electronic and structural properties between the polylinker polymer and the nanoparticles.

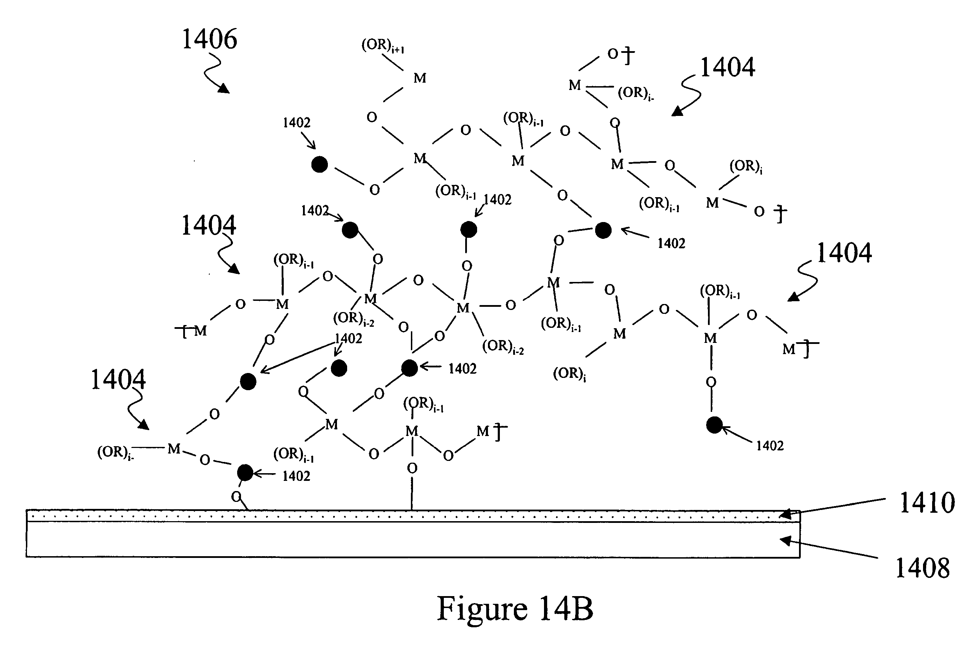

Figure 14B depicts the chemical structure **1406** of an illustrative example of the interconnected nanoparticle film **1400** from Figure 14A formed on a flexible substrate 1408 that includes an oxide layer coating **1410,** which is an electrical conductor. In particular, the polylinkers may be used to facilitate the formation of such nanoparticle films **1400** on flexible, significantly light transmitting substrates **1408.** As used herein, the term "significantly light transmitting substrate" refers to a substrate that transmits at least about 60% of the visible light incident on the substrate in a wavelength range of operation. Examples of flexible substrates **1408** include polyethylene terephthalates (PETs), polyimides, polyethylene naphthalates (PENs), polymeric hydrocarbons, cellulosics, combinations thereof, and the like. PET and PEN substrates may be coated with one or more electrical conducting, oxide layer coatings **1410** of, for example, indium tin oxide (ITO), a fluorine-doped tin oxide, tin oxide, zinc oxide, and the like.

According to one example, by using the illustrative polylinkers, the methods interconnect nanoparticles **1402** at temperatures significantly below 400 °C, and preferably below about 300 °C. Operating in such a temperature range enables the use of the flexible substrates **1408,** which would otherwise be destructively deformed by conventional high temperature sintering methods. In one illustrative example, the exemplary structure **1406** is formed by interconnecting the nanoparticles 1402 using a polylinker **1404** on a substrate **1408** at temperatures below about 300 °C. In another example, the nanoparticles **1402** are interconnected using a polylinker **1404** at temperatures below about 100 °C. In still another example, the nanoparticles **1402** are interconnected using a polylinker **1404** at about room temperature and room pressure, from about 18 to about 22 °C and about 760 mm Hg, respectively.

In examples where the nanoparticles are deposited on a substrate, the reactive groups of the polylinker bind with the substrate, substrate coating and/or substrate oxide layers. The reactive groups may bind to the substrate, substrate coating and/or substrate oxide layers by, for example, covalent, ionic and/or hydrogen bonding. It is believed that reactions between the reactive groups of the polylinker with oxide layers on the substrate result in connecting nanoparticles to the substrate via the polylinker.

According to various examples, metal oxide nanoparticles are interconnected by contacting the nanoparticles with a suitable polylinker dispersed in a suitable solvent at or below room temperature or at elevated temperatures below about 300 °C. The nanoparticles may be contacted with a polylinker solution in many ways. For example, a nanoparticle film may be formed on a substrate and then dipped into a polylinker solution. A nanoparticle film may be formed on a substrate and the polylinker solution sprayed on the film. The polylinker and nanoparticles may be dispersed together in a solution and the solution deposited on a substrate. To prepare nanoparticle dispersions, techniques such as, for example, microfluidizing, attritting, and ball milling may be used. Further, a polylinker solution may be deposited on a substrate and a nanoparticle film deposited on the polylinker.

In examples where the polylinker and nanoparticles are dispersed together in a solution, the resultant polylinker-nanoparticle solution may be used to form an interconnected nanoparticle film on a substrate in a single step. In various versions of this example, the viscosity of the polylinker-nanoparticle solution may be selected to facilitate film deposition using printing techniques such as, for example, screen-printing and gravure-printing techniques. In examples where a polylinker solution is deposited on a substrate and a nanoparticle film deposited on the polylinker, the concentration of the polylinker can be adjusted to achieve a desired adhesive thickness. In addition, excess solvent may be removed from the deposited polylinker solution prior to deposition of the nanoparticle film.

The examples are not limited to interconnection of nanoparticles of a material of formula MₓO_{y}. Suitable nanoparticle materials include, but are not limited to, sulfides, selenides, tellurides, and oxides of titanium, zirconium, lanthanum, niobium, tin, tantalum, terbium, and tungsten, and combinations thereof. For example, TiO₂, SrTiO₃, CaTiO₃, ZrO₂, WO₃, La₂O₃, Nb₂O₅, SnO₂, sodium titanate, and potassium niobate are suitable nanoparticle materials.

The polylinker may contain more than one type of reactive group. For example, the illustrative examples of Figures 12-14B depict one type of reactive group OR. However, the polylinker may include several types of reactive groups, e.g., OR, OR', OR", etc.; where R, R' and R" are one or more of a hydrogen, alkyl, alkene, alkyne, aromatic, or acyl group or where one or more of OR, OR', and OR" are a halide. For example, the polylinker may include polymer units of formulas such as, -[O-M(OR)ᵢ(OR')ⱼ-]-, and -[O-M(OR)ᵢ(OR')ⱼ(OR")ₖ-]-, where i, j and k are integers greater than zero.

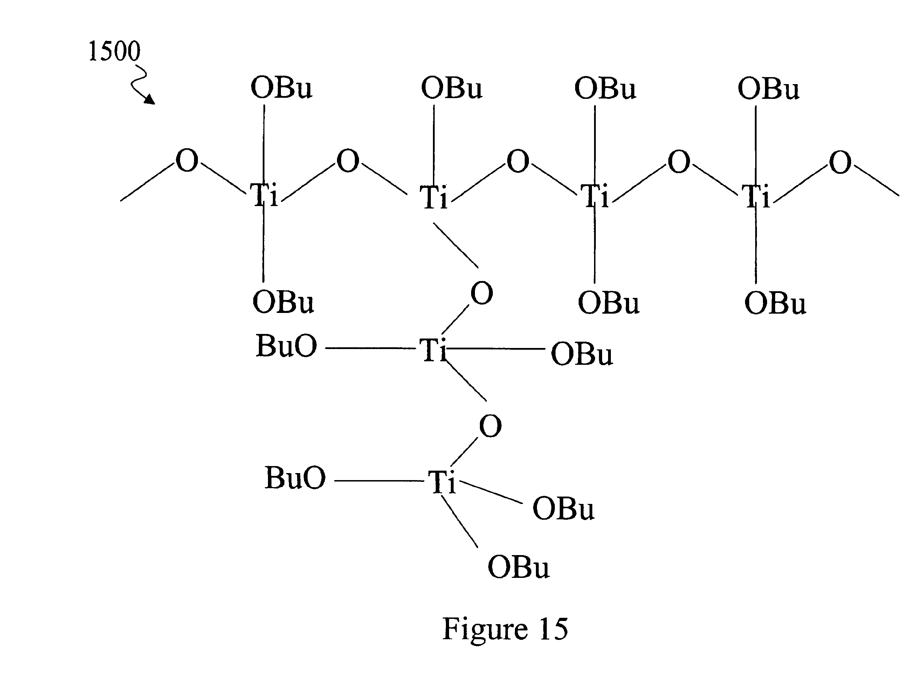

Figure 15 depicts the chemical structure of a representative polylinker, poly(n-butyl titanate) **1500** for use with titanium dioxide (TiO₂) nanoparticles. Suitable solvents for poly(n-butyl titanate) **1500** include, but are not limited to, various alcohols, chlorohydrocarbons (e.g., chloroform), ketones, cyclic and linear chain ether derivatives, and aromatic solvents among others. Preferably, the solvent is n-butanol. The poly(n-butyl titanate) polylinker **1500** contains a branched Ti-O-Ti-O-Ti-O- backbone structure with butoxy (OBu) reactive groups.

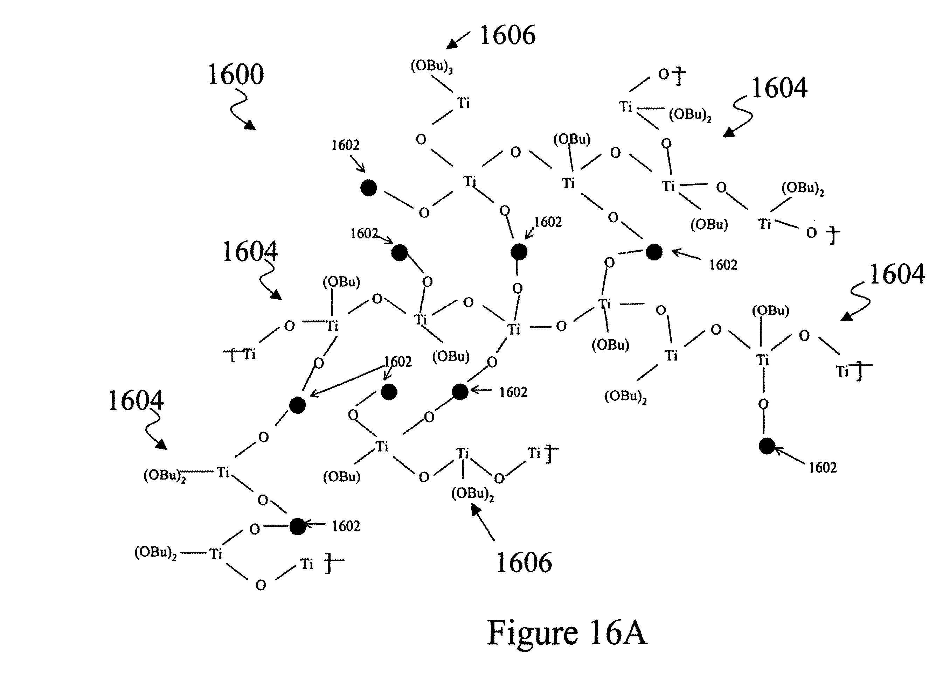

Figure 16A depicts the chemical structure of a nanoparticle film **1600,** which is constructed from titanium dioxide nanoparticles **1602** interconnected by poly(n-butyl titanate) polylinker molecules **1604.** It is believed that the reaction between surface hydroxyl groups of the TiO₂ nanoparticles **1602** with butoxy groups **1606** (or other alkoxy groups) of the polylinker **1604** leads to the bridging (or linking) of many nanoparticles **1602** together through highly stable covalent links, and as a result, interconnecting the nanoparticles **1602.** Furthermore, it is believed that since the polylinker **1604** is a polymeric material with a chemical structure similar to that of TiO₂, even a few binding (or linking) sites between nanoparticles **1602** and polylinker **1604** will lead to a highly interconnected nanoparticle film **1600,** with electronic and mechanical properties superior to those of a non-sintered or non-interconnected nanoparticle film.

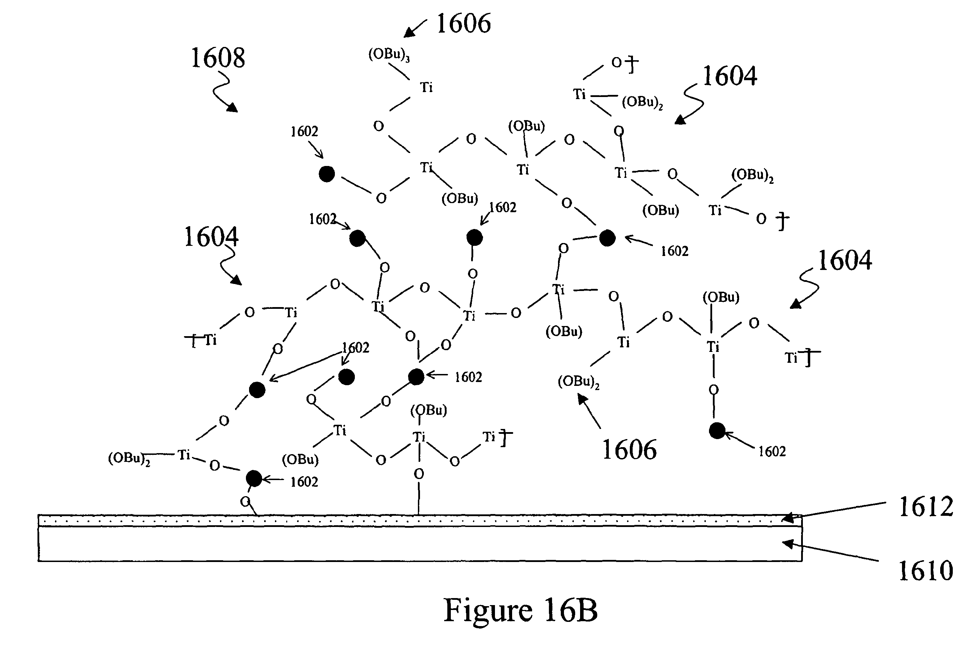

Figure 16B depicts the chemical structure **1608** of the nanoparticle film **1600** from Figure 16A formed on a substrate **1610,** which includes an electrically-conducting oxide layer coating **1612,** by applying the polylinker solution to the substrate **1610** and then depositing the nanoparticles **1602** on the polylinker **1604.** In the illustrative example using titanium dioxide nanoparticles **1602,** a polylinker solution including poly(n-butyl titanate) **1604** is dissolved in n-butanol and applied to the substrate **1610.** The concentration of the polylinker **1604** can be adjusted to achieve a desired adhesive thickness for the polylinker solution. A titanium dioxide nanoparticulate film **1600** is then deposited on the polylinker coated substrate **1610.** Reaction between the surface hydroxyl groups of the TiO₂ nanoparticles with reactive butoxy groups 1606 (or other alkoxy groups) of poly(n-butyl titanate) **1604** results in interconnecting the nanoparticles **1602,** as well as connecting nanoparticles **1602** with the oxide layers **1612** on the substrate **1610.**

### Example 1. Dip-Coating Application of Polylinker

In this illustrative example, a DSSC was formed as follows. A titanium dioxide nanoparticle film was coated on a SnO₂:F coated glass slide. The polylinker solution was a 1% (by weight) solution of the poly(n-butyl titanate) in n-butanol. In this example, the concentration of the polylinker in the solvent was preferably less than 5% by weight. To interconnect the particles, the nanoparticle film coated slide was dipped in the polylinker solution for 15 minutes and then heated at 150 °C for 30 minutes. The polylinker treated TiO₂ film was then photosensitized with a 3 x 10⁻⁴ N3 dye solution for 1 hour. The polylinker treated TiO₂ film coated slide was then fabricated into a 0.6 cm² photovoltaic cell by sandwiching a triiodide based liquid redox electrolyte between the TiO₂ film coated slide a platinum coated SnO₂:F glass slide using 2 mil SURLYN 1702 hot melt adhesive available from DuPont. The platinum coating was approximately 60 nm thick. The cell exhibited a solar conversion efficiency of as high as 3.33% at AM 1.5 solar simulator conditions (i.e., irradiation with light having an intensity of 1000 W/m²), The completed solar cells exhibited an average solar conversion efficiency ("η") of 3.02%; an average open circuit voltage ("V_{oc}") of 0.66 V; an average short circuit current ("I_{sc}") of 8.71 mA/cm², and an average fill factor of 0.49 (0.48 to 0.52).

### Example 2. Polylinker-Nanoparticle Solution Application

In this illustrative example, a 5.0 mL suspension of titanium dioxide (P25, which is a titania that includes approximately 80% anatase and 20% rutile crystalline TiO₂ nanoparticles and which is available from Degussa-Huls) in n-butanol was added to 0.25 g of poly(n-butyl titanate) in 1 mL of n-butanol. In this example, the concentration of the polylinker in the polylinker-nanoparticle solution was preferably less than about 50% by weight. The viscosity of the suspension changed from milk-like to toothpaste-like with no apparent particle separation. The paste was spread on a patterned SnO₂:F coated glass slide using a Gardner knife with a 60 µm thick tape determining the thickness of wet film thickness. The coatings were dried at room temperature forming the films. The air-dried films were subsequently heat treated at 150 °C for 30 minutes to remove solvent, and sensitized overnight with a 3 x 10⁻⁴ M N3 dye solution in ethanol. The sensitized photoelectrodes were cut into desired sizes and sandwiched between a platinum (60 nm thick) coated SnO₂:F coated glass slide and a tri-iodide based liquid electrolyte. The completed solar cells exhibited an average η of 2.9% (2.57% to 3.38%) for six cells at AM 1.5 conditions. The average V_{oc} was 0.68 V (0.66 to 0.71 V); the average I_{sc} was 8.55 mA/cm² (7.45 to 10.4 mA/cm²); and the average fill factor was 0.49 (0.48 to 0.52).

### Example 3. DSSC Cells Formed Without Polylinker

In this illustrative example, an aqueous titanium dioxide suspension (P25) containing about 37.5 % solid content was prepared using a microfluidizer and was spin coated on a fluorinated SnO₂ conducting electrode (15 Ω/cm²) that was itself coated onto a coated glass slide. The titanium dioxide coated slides were air dried for about 15 minutes and heat treated at 150 °C for 15 minutes. The slides were removed from the oven, cooled to about 80 °C, and dipped into 3 x 10⁻⁴ M N3 dye solution in ethanol for about 1 hour. The sensitized titanium dioxide photoelectrodes were removed from dye solution rinsed with ethanol and dried over a slide warmer at 40 °C. The sensitized photoelectrodes were cut into small pieces (0.7 cm x 0.5-1 cm active area) and sandwiched between platinum coated SnO₂:F-transparent conducting glass slides. A liquid electrolyte containing 1 M LiI, 0.05 M iodine, and 1 M t-butyl pyridine in 3-methoxybutyronitrile was applied between the photoelectrode and platinized conducting electrode through capillary action. Thus constructed photocells exhibited an average solar conversion efficiency of about 3.83 % at AM 1.5 conditions. The η at AM 1.5 conditions and the photovoltaic characteristics I_{sc}, V_{oc}, voltage at maximum power output ("Vₘ"), and current at maximum power output ("Iₘ") of these cells are listed in Table 1 under column A.

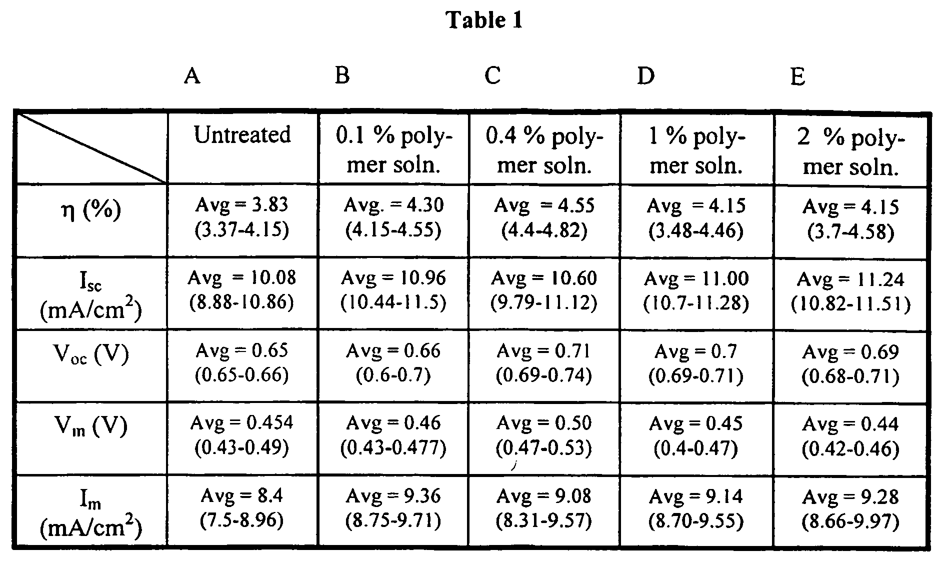

### Example 4. DSSC Cells Formed With Various Concentrations of Polylinker Solution

In this illustrative example, a P25 suspension containing about 37.5 % solid content was prepared using a microfluidizer and was spin coated on fluorinated SnO₂ conducting electrode (15 Ω/cm²) coated glass slide. The titanium dioxide coated slides were air dried for about 15 minutes and heat treated at 150 °C for 15 minutes. The titanium dioxide coated conducting glass slide were dipped into a polylinker solution including poly(n-butyl titanate) in n-butanol for 5 minutes in order to carry out interconnection (polylinking) of nanoparticles. The polylinker solutions used were 0.1 wt% poly(n-butyl titanate), 0.4 wt% poly(n-butyl titanate), 1 wt% poly(n-butyl titanate), and 2 wt% poly(n-butyl titanate). After 5 minutes, the slides were removed from the polylinker solution, air dried for about 15 minutes and heat treated in an oven at 150 °C for 15 minutes to remove solvent. The slides were removed from the oven, cooled to about 80 °C, and dipped into 3 x 10⁻⁴ M N3 dye solution in ethanol for about 1 hour. The sensitized titanium dioxide photoelectrodes were removed from dye solution, rinsed with ethanol, and dried over a slide warmer at 40 °C. The sensitized photoelectrodes were cut into small pieces (0.7 cm x 0.5-1 cm active area) and sandwiched between platinum coated SnO₂:F-transparent conducting glass slides. A liquid electrolyte containing 1 M LiI, 0.05 M iodine, and 1 M t-butyl pyridine in 3-methoxybutyronitrile was applied between the photoelectrode and platinized conducting electrode through capillary action. The η at AM 1.5 conditions and the photovoltaic characteristics I_{sc}, V_{oc}, Vₘ, and Iₘ of the constructed cells are listed in Table 1 for the 0.1 wt% solution under column B, for the 0.4 wt% solution under column C, for the 1 wt% solution under column D, and for the 2 wt% solution under column E.

### Example 5. Modifier Solutions

In this illustrative example, titanium dioxide coated transparent conducting oxide coated glass slides were prepared by spin coating process as described in Example 4. The titanium oxide coated conducting glass slides were treated with polylinker solution including a 0.01 M poly(n-butyl titanate) solution in n-butanol for 5 minutes to interconnect the nanoparticles. The slides were air dried for about 5 minutes after removing from the polylinker solution. The slides were later dipped into a modifier solution for about 1 minute. The modifier solutions used were 1:1 water/ethanol mixture, 1 M solution of t-butyl pyridine in 1:1 water/ethanol mixture, 0.05 M HCl solution in 1:1 water/ethanol mixture. One of the slides was treated with steam from humidifier for 15 seconds. The slides were air dried for 15 minutes and heat-treated at 150 °C for 15 minutes to remove solvent and then sensitized with a 3 x 10⁻⁴ M N3 dye solution for 1 hour. The sensitized photoelectrodes were sandwiched between platinized SnO₂:F coated glass slides and studied for photovoltaic characteristics using a liquid electrolyte containing 1 M LiI, 0.05 M iodine, and 1 M t-butyl pyridine in 3-methoxybutyronitrile. Acid seems to help in increasing the photoconductivity and efficiency of these photocells. The η at AM 1.5 conditions and the photovoltaic characteristics of the cells of this example are listed in Table 2 as follows: slides not dipped into a modifier solution and not treated with polylinker solution (column A); slides not dipped into a modifier, but treated with polylinker solution (column B); slides were first treated with polylinker solution and then dipped in 1:1 water/ethanol mixture (column C); slides were first treated with polylinker solution and then dipped in 1 M solution of t-butyl pyridine in 1:1 water/ethanol mixture (column D); slides were first treated with polylinker solution and then dipped in 0.05 M HCl solution in 1:1 water/ethanol mixture (column E); and slides were first treated with polylinker solution and then treated with steam from humidifier (column F).

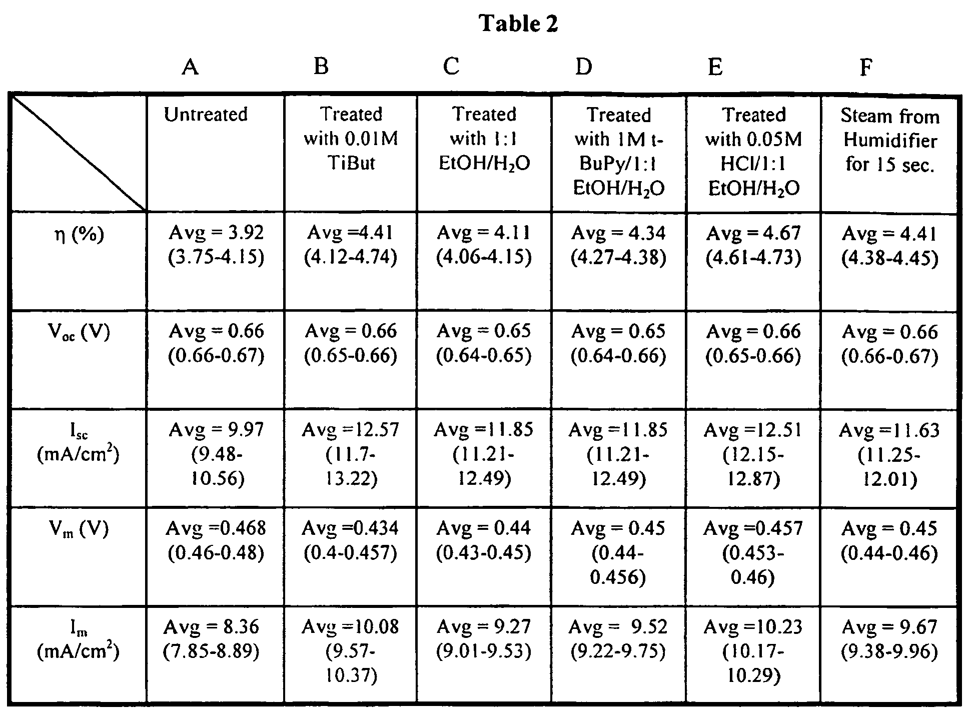

### Example 6. Post-Interconnection Heating to 150 °C

In this illustrative example, a titanium-dioxide-coated, transparent-conducting-oxide-coated glass slide was prepared by a spin coating process as described in Example 4. The slide was dipped into 0.01 M poly(n-butyl titanate) in n-butanol for 30 seconds and was air-dried for 15 minutes. The slide was later heat treated at 150 °C for 10 minutes in an oven. The heat-treated titanium oxide layer was sensitized with N3 dye solution for 1 hour, washed with ethanol, and warmed on a slide warmer at 40 °C for 10 minutes. The sensitized photoelectrodes were cut into 0.7 cm x 0.7 cm active area photocells and were sandwiched between platinized conducting electrodes. A liquid electrolyte containing 1 M LiI, 0.05 M iodine, and 1 M t-butyl pyridine in 3-methoxybutyronitrile was applied between the photoelectrode and platinized conducting electrode through capillary action. The photocells exhibited an average η of 3.88 % (3.83, 3.9 and 3.92), an average V_{oc} of 0.73 V (0.73, 0.74 and 0.73 V), and an average I_{sc} of 9.6 mA/cm² (9.88, 9.65 and 9.26), all at AM 1.5 conditions.

### Example 7. Post-Interconnection Heating to 70 °C

In this illustrative example, a titanium-dioxide-coated, transparent-conducting- oxide-coated glass slide was prepared by a spin coating process as described in Example 4. The slide was dipped into 0.01 M poly(n-butyl titanate) in n-butanol for 30 seconds and was air-dried for 15 minutes. The slide was later heat treated at 70 °C for 10 minutes in an oven. The heat-treated titanium oxide layer was sensitized with N3 dye solution for 1 hour, washed with ethanol, and warmed on a slide warmer at 40 °C for 10 minutes. The sensitized photoelectrodes were cut into 0.7 cm x 0.7 cm active area photocells and were sandwiched between platinized conducting electrodes. A liquid electrolyte containing 1 M LiI, 0.05 M iodine, and 1 M t-butyl pyridine in 3-methoxybutyronitrile was applied between the photoelectrocte and platinized conducting electrode through capillary action. The photocells exhibited an average η of 3.62 % (3.55, 3.73 and 3.58), an average V_{oc} of 0.75 V (0.74, 0.74 and 0.76 V), and average I_{sc} of 7.96 mA/cm² (7.69, 8.22 and 7.97), all at AM 1.5 conditions.

### Example 8. Formation on a Flexible, Transparent Substrate

In this illustrative example, a PET substrate about 200 µm thick and about 5 inches by 8 feet square was coated with ITO and loaded onto a loop coater. An 18.0 mL suspension of titanium dioxide (P25 with 25% solid content) in n-butanol and 0.5 g of poly(n-butyl titanate) in 10 mL of n-butanol were in-line blended and coated onto the ITO coated PET sheet. After deposition, the coating was heated at about 50 °C for about 1 minute. The interconnected nanoparticle layer was then dye-sensitized by coating with a 3 x 10⁻⁴ M solution of N3 dye in ethanol

### C. Gel electrolytes for DSSCs

According to further illustrative examples, there are disclosed electrolyte compositions that include multi-complexable molecules (i.e., molecules containing 2 or more ligands capable of complexing) and redox electrolyte solutions, which are gelled using metal ions, such as lithium ions. The multi-complexable compounds are typically organic compounds capable of complexing with a metal ion at a plurality of sites. The electrolyte composition can be a reversible redox species that may be liquid by itself or solid components dissolved in a non-redox active solvent, which serves as a solvent for the redox species and does not participate in reduction-oxidation reaction cycle. Examples, include common organic solvents and molten salts that do not contain redox active ions. Examples of redox species include, for example, iodide/triiodide, Fe²⁺/Fe³⁺, Co²⁺/Co³⁺, and viologens, among others. The redox components are dissolved in non-aqueous solvents, which include all molten salts. Iodide based molten salts, e.g., methylpropylimidazolium iodide, methylbutylimidazolium iodide, methylhexylimidazolium iodide, etc., are themselves redox active and can be used as redox active liquids by themselves or diluted with non-redox active materials like common organic solvents or molten salts that do not undergo oxidation-reduction reaction cycles. Multi-dendate inorganic ligands may also be a source of gelling compounds.

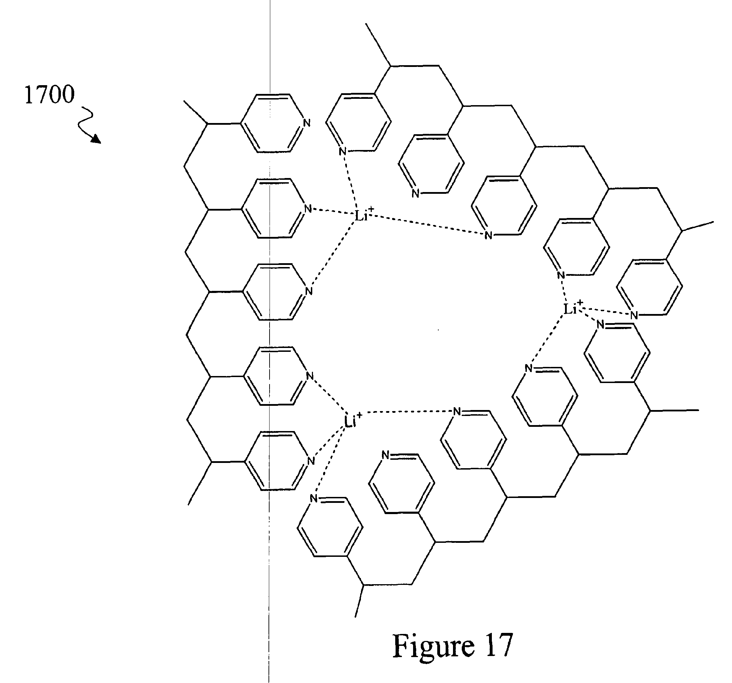

Figure 17 depicts an illustrative example **1700** of an electrolyte gelled using metal ions. Lithium ions are shown complexed with poly(4-vinyl pyridine). The lithium ions and the organic compounds, in this instance poly(4-vinyl pyridine) molecules capable of complexing at a plurality of sites with the lithium ions, can be used to gel a suitable electrolyte solution. An electrolyte composition may include small amounts of water, molten iodide salts, an organic polymer, and other suitable compound gels upon the addition of a metal ion such as lithium. Gelled electrolytes may be incorporated into individual flexible photovoltaic cells, traditional solar cells, photovoltaic fibers, interconnected photovoltaic modules, and other suitable devices. The dotted lines shown in Figure 17 represent the type of bonding that occurs in a photovoltaic gel electrolyte when the constituent electrolyte solution and organic compounds gel after the introduction of a suitable metal ion.

A non-exhaustive list of organic compounds that are capable of complexing with the metal ion at a plurality of sites, include various polymers, starburst/dendrimeric molecules, and other molecules containing multiple functional groups, e.g., urethanes, esters, ethylene/propylene oxide/imines segments, pyridines, pyrimidines, N-oxides, imidazoles, oxazoles, triazoles, bipyridines, quinolines, polyamines, polyamides, ureas, β-diketones, and β-hydroxyl ketones.

More generally, the multi-complexable molecules employed in various examples may be polymeric or small organic molecules that possess two or more ligand or ligating groups capable of forming complexes. Ligating groups are functional groups that contain at least one donor atom rich in electron density, e.g., oxygen, nitrogen, sulfur, or phosphorous, among others and form monodentate or multidentate complexes with an appropriate metal ion. The ligating groups may be present in non-polymeric or polymeric material either in a side chain or part of the backbone, or as part of a dendrimer or starburst molecule. Examples of monodentate ligands include, for example, ethyleneoxy, alkyl-oxy groups, pyridine, and alkyl-imine compounds, among others. Examples of bi- and multidentate ligands include bipyridines, polypyridines, urethane groups, carboxylate groups, and amides.

According to various examples, dye-sensitized photovoltaic cells having a gel electrolyte **1700** including lithium ions are fabricated at or below room temperature or at elevated temperatures below about 300 °C. The temperature may be below about 100 °C, and preferably, the gelling of the electrolyte solution is performed at room temperature and at standard pressure. In various illustrative examples, the viscosity of the electrolyte solution may be adjusted to facilitate gel electrolyte deposition using printing techniques such as, for example, screen-printing and gravure-printing techniques. The complexing of lithium ions with various ligands can be broken at higher temperatures, thereby permitting the gel electrolyte compositions to be easily processed during DSSC based photovoltaic module fabrication. Other metal ions may also be used to form thermally reversible or irreversible gels. Examples of suitable metal ions include: Li⁺, Cu²⁺, Ba²⁺, Zn²⁺, Ni²⁺, Ln³⁺(or other lanthanides), Co²⁺, Ca²⁺, Al³⁺, Mg²⁺, and any metal ion that complexes with a ligand.

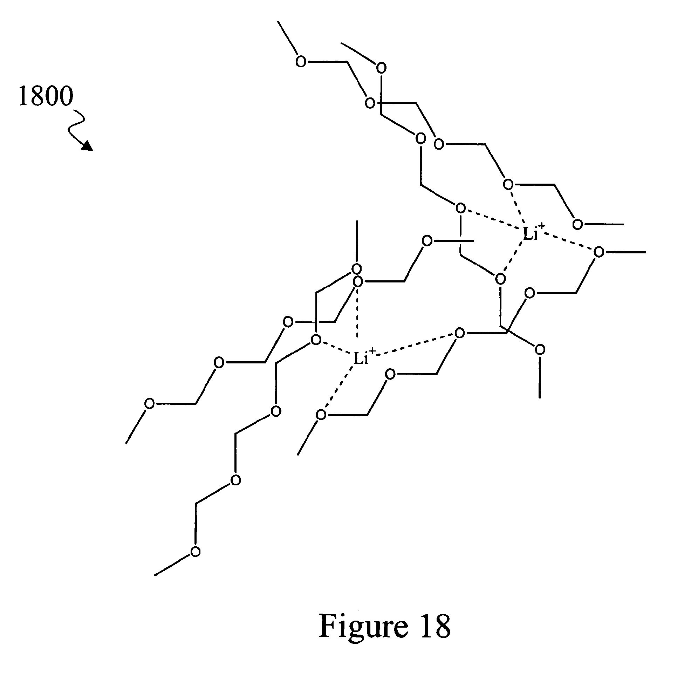

Figure 18 depicts a gel electrolyte 1800 formed by the complexing of an organic polymer, polyethylene oxide (PEO), by lithium ions. The PEO polymer segments are shown as being complexed about the lithium ions and crosslinked with each other. In another example, the metal ion complexed with various polymer chains can be incorporated into a reversible redox electrolyte species to promote gelation. The gel electrolyte composition that results from the combination is suitable for use in various photovoltaic cells such as photovoltaic fibers, photovoltaic cells, and electrically interconnected photovoltaic modules.

Referring back to Figures 1-4, the charge carrier material **115, 215, 315**, and **415** can include an electrolyte composition having an organic compound capable of complexing with a metal ion at a plurality of sites; a metal ion such as lithium; and an electrolyte solution. These materials can be combined to produce a gelled electrolyte composition suitable for use in the charge carrier material **115, 215, 315,** and **415** layer. In one example, the charge carrier material **115, 215, 315**, and **415** includes a redox system. Suitable redox systems may include organic and/or inorganic redox systems. Examples of such systems include, but are not limited to, cerium(III) sulfate/cerium(IV), sodium bromide/bromine, lithium iodide/iodine, Fe²⁺/Fe³⁺, Co²⁺/Co³⁺, and viologens.

Further illustrative examples in the context of a DSSC having a gel electrolyte composition are provided below. The photoelectrodes used in the following illustrative examples were prepared according to the following procedure. An aqueous, titania suspension (P25, which was prepared using a suspension preparation technique with total solid content in the range of 30-37 %) was spun cast on SnO₂:F coated glass slides (15 Ωcm²). The typical thickness of the titanium oxide coatings was around 8 µm. The coated slides were air dried at room temperature and sintered at 450 °C for 30 minutes. After cooling the slides to about 80 °C, the slides were immersed into 3×10⁻⁴ M N3 dye solution in ethanol for 1 hour. The slides were removed and rinsed with ethanol and dried over slide a warmer at 40 °C for about leo minutes. The slides were cut into about 0.7 cm × 0.7 cm square active area cells. The prepared gels were applied onto photoelectrodes using a glass rod and were sandwiched between platinum-coated, SnO₂:F coated, conducting glass slides. The cell performance was measured at AM 1.5 solar simulator conditions (i.e., irradiation with light having an intensity of 1000 W/m²).

### Example 9. Effect of Lithium Iodide in Standard Ionic Liquid Based Electrolyte Composition

In this illustrative example, the standard, ionic, liquid-based redox electrolyte composition that was used contained a mixture containing 99 % (by weight) imidazolium iodide based ionic liquid and 1 % water (by weight), combined with 0.25 M iodine and 0.3 M methylbenzimidazole. In various experimental trials, electrolyte solutions with at least a 0.10 M iodine concentration exhibit the best solar conversion efficiency. In a standard composition, butylmethylimidazolium iodide (MeBuImI) was used as the ionic liquid. Photovoltage decreased with increases in iodine concentration, while photoconductivity and conversion efficiency increased at least up to 0.25 M iodine concentration. Adding lithium iodide to the standard composition enhanced the photovoltaic characteristics V_{oc} and I_{sc} and the η. Therefore, in addition to lithium's use as a gelling agent, it may serve to improve overall photovoltaic efficiency. Table 3 summarizes the effect of LiI on photovoltaic characteristics.

**Table 3**

| | Standard | Standard + 1 wt% Lil | Standard + 2 wt% Lil | Standard + 3 wt% Lil | Standard + 5 wt% Lil |
|---|---|---|---|---|---|
| η (%) | 2.9% | 3.57 | 3.75 | 3.70 | 3.93 |
| V_{oc} (V) | 0.59 | 0.61 | 0.6 | 0.6 | 0.61 |
| I_{sc} (mA/ cm²) | 10.08 | 11.4 | 11.75 | 11.79 | 12.62 |
| Vₘ (V) | 0.39 | 0.4 | 0.39 | 0.4 | 0.39 |
| lm (mA/ cm²) | 7.44 | 9.02 | 9.64 | 9.0 | 10.23 |

The fill factor ("FF") is referenced below and can be calculated from the ratio of the solar conversion efficiency to the product of the open circuit voltage and the short circuit current, i.e., FF =η/[V_{oc}*I_{sc}].

### Example 10. The Effect of Cations on the Enhancement in Photovoltaic Characteristics

In order to ascertain whether the enhancement in photovoltaic characteristics was due to the presence of lithium or iodide, controlled experimental trials using various iodides in conjunction with cations including lithium, potassium, cesium and tetrapropylammonium iodide were conducted. The iodide concentration was fixed at 376 µmols/gram of standard electrolyte composition. The standard composition used was a mixture containing 99 % MeBuImI and 1 % water, combined with 0.25 M iodine and 0.3 M methylbenzimidazole. 376 µmols of various iodide salts per gram of standard electrolyte composition were dissolved in the electrolyte. The complete dissolution of Lil was observed. The other salts took a long time to dissolve and did not dissolve completely over the course of the experimental trial. DSSC-based photovoltaic cells were fabricated using prepared electrolytes containing various cations. Table 4 shows the effect of the various cations on the photovoltaic characteristics. It is apparent from the second column of Table 4 that Li⁺ ion shows enhanced photovoltaic characteristics compared to the standard formula, while the other cations do not appear to contribute to the enhancement of the photovoltaic characteristics.

**Table 4**

| | Standard | Standard + Lil | Standard + NPR₄I | Standard + Kl | Standard + CsI |
|---|---|---|---|---|---|
| η (%) | 3.23 | 4.39 | 2.69 | 3.29 | 3.23 |
| V_{oc} (V) | 0.58 | 0.65 | 0.55 | 0.58 | 0.6 |
| I_{sc} (mA/cm²) | 10.96 | 12.03 | 9.8 | 9.91 | 10.14 |
| Vₘ (V) | 0.36 | 0.44 | 0.36 | 0.4 | 0.4 |
| Iₘ (mA/ cm²) | 8.96 | 9.86 | 7.49 | 8.25 | 8.32 |

### Example 11. Effect of Ionic Liquid Type

In one example, MeBuImI-based electrolyte compositions have been found to perform slightly better than MePrImI based electrolytes. In addition, experimental results demonstrate that a 1/1 blend of MeBuImI and MePrImI exhibit better performance than MeBuImI, as shown in Table 5.

**Table 5**

| | **376 µmoles of LiI per 1 gram of MeBuIml based standard electrolyte composition** | **376 umoles of LiI per 1 gram of MeBuImI/MePrImI based standard electrolyte composition.** |
|---|---|---|
| η(%) | 3.64 | 3.99 |
| V_{oc} (V) | 0.63 | 0.63 |
| I_{sc} (mA/ cm²) | 11.05 | 11.23 |
| Vₘ (V) | 0.42 | 0.42 |
| Iₘ (mA/ cm²) | 8.69 | 9.57 |

### Example 12. Using Li-induced Gelling in Composition A Instead of a Dibromocompound

In this illustrative example, a Composition A was prepared by dissolving 0.09 M of iodine in a mixed solvent consisting of 99.5% by weight of 1-methyl-3-propyl imidazolium iodide and 0.5% by weight of water. Then, 0.2 g of poly(4-vinylpyridine) ("P4VP"), a nitrogen-containing compound, was dissolved in 10 g of the Composition A Further, 0.2 g of 1,6-dibromohexane, an organic bromide, was dissolved in the resultant Composition A solution, so as to obtain an electrolyte composition, which was a precursor to a gel electrolyte.

Gelling occurred quickly when 5 wt % of lithium iodide (376 µmols of lithium salt per gram of standard electrolyte composition) was used as the gelling agent in an electrolyte composition containing (i) 2 wt % P4VP and (ii) a mixture containing 99.5 % MePrImI and 0.5% water. The gel did not flow when a vial containing the Li-induced gel was tilted upside down. One approach using a dibromo compound produced a phase-segregated electrolyte with cross-linked regions suspended in a liquid, which flows (even after gelling at 100 °C for 30 minutes). A comparison of the photovoltaic characteristics of Composition A, with and without LiI, is presented in the following Tables 6 and 7. The results demonstrate that functional gels suitable for DSSC-based photovoltaic cell fabrication can be obtained using lithium ions, while also improving the photovoltaic characteristics.

**Table 6**

| | Composition A with dibromohexane | Composition A with 2 wt% P4VP | MeBulml based electrolyte+ 2 wt% P4VP+5 wt.% LiI |
|---|---|---|---|
| η (%) | 2.6 | 3.04 | 3.92 |
| V_{oc} (V) | 0.59 | 0.58 | 0.65 |
| I_{sc} (mA/ cm²) | 9.73 | 10.0 | 11.45 |
| Vₘ (V) | 0.38 | 0.38 | 0.42 |
| Iₘ (mA/ cm²) | 6.82 | 8.04 | 9.27 |

**Table 7**

| | (a) Composition A where MePrImI:water is 99.5:0.5 and with 2 % P4VP and 0.09 M Iodine | (b) Same composition as (a), but with 5 wt % of LiI |
|---|---|---|
| Physical Properties | Reddish fluid; flows well | Non-scattering Gel; does not flow; can be thinned by applying force using a glass rod. |
| Efficiency | 2.53 % | 3.63 % |
| V_{oc} | **0.55 V** | **0.62 V** |
| I_{sc} | **9.82 mA/cm²** | **12.29 mA/cm²** |
| Vₘ | **0.343 V** | **0.378 V** |
| FF | **0.47** | **0.47** |

### Example 13. Effect of Anions of Lithium Salts on the Efficiency and Photovoltage of DSSCs

Experiments were performed to study the effect of counter ions on lithium, given lithium's apparent role in enhancing the overall efficiency of DSSCs. 376 µmols of LiI, LiBr, and LiCl were used per gram of the electrolyte composition containing MePrImI, 1 % water, 0.25 M iodine and 0.3 M methylbenzimidazole in order to study the photovoltaic characteristics of the cells. The photovoltaic characteristics of cells containing these electrolytes are presented in Table 8.

**Table 8**

| | Electrolyte composition with LiI | Electrolyte composition with LiBr | Electrolyte composition with LiCl |
|---|---|---|---|
| Efficiency | 3.26% | 3.64 % | 3.71% |
| V_{oc} | **0.59 V** | **0.62 V** | **0.65 V** |
| I_{sc} | **10.98 mA/cm²** | **11.96 mA/cm²** | **11.55 mA/cm²** |
| Vₘ | **0.385 V** | **0.4 V** | **0.40 V** |
| FF | 0.5 | 0.49 | 0.49 |

### Example 14. Passivation and Improved Efficiency and Photovoltage of DSSCs

In the field of photovoltaic cells, the term passivation refers to the process of reducing electron transfer to species within the electrolyte of a solar cell. Passivation typically includes treating a nanoparticle layer by immersion in a solution of t-butylpyridine in methoxypropionitrile or other suitable compound. After the nanomatrix layer, such as a titania sponge, of a photovoltaic cell has been treated with a dye, regions in the nanomatrix layer where the dye has failed to adsorb may exist. A passivation process is typically performed on a DSSC to prevent the reversible electron transfer reaction from terminating as result of reducing agents existing at the undyed regions. The typical passivation process does not appear to be necessary when ionic liquid compositions containing various lithium salts and/or other alkali metal salts are used in the DSSCs. A photovoltage greater than 0.65 V was achieved using a chloride salt of lithium without a passivation process.

In this illustrative example, a DSSC was passivated by immersing it in a solution containing 10 wt % of t-butylpyridine in methoxypropionitrile for 15 minutes. After passivation, the DSSC was dried on a slide warmer maintained at 40 °C for about 10 minutes. Electrolyte compositions containing MePrImI, 1% water, 0.3 M methylbenzimidazole, and 0.25 M iodine were gelled using 376 µmoles of LiI, LiBr, and LiCl per gram of standard electrolyte composition used during this study. Adding a t-butylpyridine-based passivation agent to the electrolyte enhanced the DSSC's photovoltage, but decreased the efficiency of the DSSC by decreasing the photoconductivity. Table 9 summarizes the effects of passivation on photovoltaic characteristics of electrolytes containing various lithium halides.

**Table 9**

| | Electrolyte gelled with LiI | Electrolyte gelled with LiBr | Electrolyte gelled with LiCl |
|---|---|---|---|
| **Efficiency** | 3.5 % | 3.65% | 3.85% |
| **V_{oc}** | **0.61 V** | **0.63 V** | **0.65 V** |
| **I_{sc}** | **10.96 mA/cm²** | **11.94 mA/cm²** | **11.75 mA/cm²** |
| **Vₘ** | **0.395 V** | **0.4 V** | **0.405 V** |
| **FF** | 0.52 | 0.49 | 0.5 |

### Example 15. Lithium's. Role in Gelling the Electrolyte Compositions Containing Polyvinylpyridine and the Effect of Other Alkali Metal Ions on Gelability

Lithium cation appears to have a unique effect in gelling ionic liquid composition containing complexable polymers, e.g., P4VP, in as small an amount as 2 wt %. Other alkali metal ions such as sodium, potassium, and cesium were used to carry out gelling experiments. Alkali metal salts such as lithium iodide, sodium chloride, potassium iodide, cesium iodide were added to portions of electrolyte composition containing propylmethylimidazolium iodide (MePrImI), 1% water, 0.25 M iodine, and 0.3 M methylbenzimidazole. Only compositions containing lithium iodide gelled under the experimental conditions used. The remaining three compositions containing sodium, potassium, and cesium did not gel at the experimental conditions used. Divalent metal ions, such as calcium, magnesium, and zinc, or trivalent metals, such as aluminum or other transition metal ions, are other potential gelling salts.

### Example 16. Effect of Iodine and Lithium Concentration on Ionic Liquid Electrolyte Gels

In this illustrative example, gels were prepared by adding lithium salts to an electrolyte composition containing MeBulml, iodine, and 2 wt % P4VP. The photovoltaic characteristics of the gels were tested using high-temperature sintered, N3 dye sensitized titanium-oxide photoelectrodes and platinized SnO₂:F coated glass slides. Both LiI and LiCl gelled the ionic liquid-based compositions that contained small amounts (2 % was sufficient) of complexable polymers like P4VP. In compositions lacking methylbenzimidazole, the lithium did not effect the photovoltage. 5 wt% corresponds to a composition including about 376 µmoles of lithium salt per gram of ionic liquid and a mixture of 99 wt% butylmethylimidazolium iodide, 1 wt% water, 0.3 M methyl benzimidazole, and 0.25 M iodine. Therefore, 1 wt% corresponds to a 376/5 ≅ 75 µmoles of lithium salt per gram of ionic liquid composition. The photovoltaic characteristics are summarized in Table 10.

**Table 10**

| | 5 % Lil | 2.5 % Lil | 5 % LiCl | 2.5 % LiCl |
|---|---|---|---|---|
| 0.05 M Iodine | η = 1.6 % | η = 1.23 % | η = 0.64 % | η = 1.19% |
| | V_{oc}=0.6V | V_{oc} = 0.59 V | V_{oc} = 0.59 V | V_{oc}: = 0.58 V |
| | I_{sc} = 4.89 mA | I_{sc} = 4.21 mA | I_{sc} = 2.95 mA | I_{sc} = 3.87 mA |
| | FF = 0.54 | FF = 0.495 | FF = 0.36 | FF = 0.53 |
| | Vₘ = 0.445 V | Vₘ = 0.415 V | Vₘ = 0.4 V | Vₘ = 0.426 V |
| 0.1 M Iodine | η = 1.22 % | η = 1.29 % | η = 2.83 % | η = 2.06 % |
| | V_{oc} = 0.48 V | V_{oc} = 0.56V | V_{oc} = 0.57 | V_{oc} = 0.58 |
| | I_{sc} = 6.46 mA | I_{sc} = 5.12 mA | I_{sc} = 9.04 mA | I_{sc} = 7.14 mA |
| | FF = 0.39 | FF = 0.45 | FF = 0.55 | FF = 0.5 |
| | Vₘ =0.349 V | Vₘ = 0.386 V | Vₘ = 0.422 V | Vₘ = 0.42 V |
| 0.25 M Iodine | η = 2.58 % | η = 3.06 % | η =3.4% | η = 2.6 % |
| | V_{oc} = 0.55 V | V_{oc} = 0.55 V | V_{oc} = 0.56 V | V_{oc} = 0.56 V |
| | I_{sc} = 11.49 mA I_{sc} | = 10.78 mA I_{sc} | = 11.32 mA | I_{sc} = 10.18 mA |
| | FF = 0.41 | FF = 0.52 | FF = 0.54 | FF = 0.46 |
| | Vₘ = 0.338 V | Vₘ = 0.36 V | Vₘ = 0.369 V | Vₘ = 0.364 V |

### Example 17. Effect of Polymer Concentration on Gelability and Photovoltaic Characteristics of Redox Electrolyte Gels

In this illustrative example, polymer concentration was varied to study its effect on gel viscosity and photovoltaic characteristics. The electrolyte composition used for this study was a mixture containing 99 % MeBuImI, 1 % water, 0.25 M iodine, 0.6 M LiI, and 0.3 M methylbenzimidazole. The concentration of the polymer, P4VP was varied from 1% to 5%. The electrolyte composition with 1% P4VP did flow slowly when the vial containing the gel was tilted down. The gels with 2%, 3%, and 5% did not flow. The gel with 5% P4VP appeared much more solid when compared to the 2% P4VP preparation. Table 11 summarizes the photovoltaic characteristics of the gels containing the various P4VP contents that were studied.

The results show that the photovoltaic characteristics do not vary with the increases in viscosity achieved by increasing the P4VP content. Therefore, the viscosity of the gel can be adjusted without causing degradation to the photovoltaic characteristics. Methylbenzimidazole may be necessary to achieve high η. Increasing the iodine concentration up to 0.25 M also increased the efficiency. Beyond 0.25 M, the photovoltage decreased drastically, reducing the overall efficiency. Other metal ions or cations like cesium, sodium, potassium or tetraalkylammonium ions were not found to contribute to the efficiency enhancement and did not cause gelling of the electrolyte solutions. Furthermore, chloride anion was found to enhance the efficiency along with lithium, by improving the photovoltage without causing decreased photoconductivity in compositions containing methylbenzimidazole.

**Table 11**

| **Photovoltaic Characteristics** | **1 % P4VP** | **2 % P4VP** | **3 % P4VP** | **5 % P4VP** |
|---|---|---|---|---|
| **η(%)** | 3.23 | 3.48 | 3.09 | 3.19 |
| **I_{sc} (mA/cm²)** | 10.74 | 10.42 | 12.03 | 10.9 |
| **V_{oc} (V)** | 0.59 | 0.59 | 0.6 | 0.61 |
| **Vₘ (V)** | 0.39 | 0.4 | 0.38 | 0.40 |
| **Iₘ (mA/cm²)** | 8.27 | 8.69 | 8.07 | 8.03 |
| **FF** | 0.51 | 0.57 | 0.43 | 0.48 |

### D. Co-sensitizers

According to one illustrative example, the photosensitizing agent described above includes a first sensitizing dye and second electron donor species, the "co-sensitizer." The first sensitizing dye and the co-sensitizer may be added together or separately to form the photosensitized interconnected nanoparticle material **112, 212, 312,** and **412** shown in Figures 1-4. As mentioned above with respect to Figures 1-4, the sensitizing dye facilitates conversion of incident visible light into electricity to produce the desired photovoltaic effect. In one illustrative example, the co-sensitizer donates electrons to an acceptor to form stable cation radicals, which improves the efficiency of charge transfer from the sensitizing dye to the semiconductor oxide nanoparticle material and reduces back electron transfer to the sensitizing dye or co-sensitizer. The co-sensitizer preferably includes (I) conjugation of the free electron pair on a nitrogen atom with the hybridized orbitals of the aromatic rings to which the nitrogen atom is bonded and, subsequent to electron transfer, the resulting resonance stabilization of the cation radicals by these hybridized orbitals; and (2) a coordinating group, such as a carboxy or a phosphate, the function of which is to anchor the co-sensitizer to the semiconductor oxide. Examples of suitable co-sensitizers include, but are not limited to, aromatic amines (e.g., such as triphenylamine and its derivatives), carbazoles, and other fused-ring analogues.

Once again referring back to Figures 1-4, the co-sensitizer is electronically coupled to the conduction band of the photosensitized interconnected nanoparticle material **112, 212, 312,** and **412.** Suitable coordinating groups include, but are not limited to, carboxylate groups, phosphate groups, or chelating groups, such as, for example, oximes or alpha keto- enolates.

Tables 12-18 below present results showing the increase in photovoltaic cell efficiency when co-sensitizers are co-adsorbed along with sensitizing dyes on the surface of high temperature sintered or low temperature interconnected titania. In Tables 12-16, characterization was conducted using AM 1.5 solar simulator conditions (i.e., irradiation with light having an intensity of 1000 W/m²). A liquid electrolyte including 1 M LiI, 1 M t-butylpyridine, 0.5 M I₂ in 3-methoxypropanitrile was employed. The data shown in the tables indicates an enhancement of one or more operating cell parameters for both low-temperature-interconnected (Tables 15, 17 and 18) and high-temperature-sintered (Tables 12, 13, 14 and 16) titania nanoparticles. The solar cells characteristics listed include η, V_{oc}, I_{sc}, FF, Vₘ, and Iₘ. The ratios of sensitizer to co-sensitizer are based on the concentrations of photosensitizing agents in the sensitizing solution.

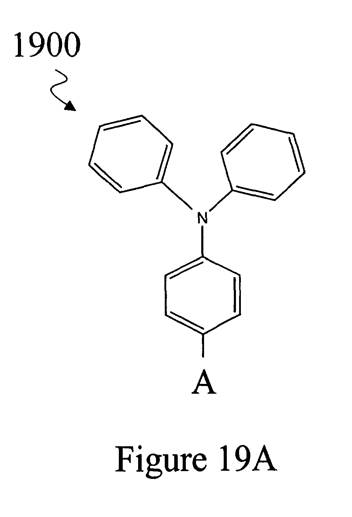

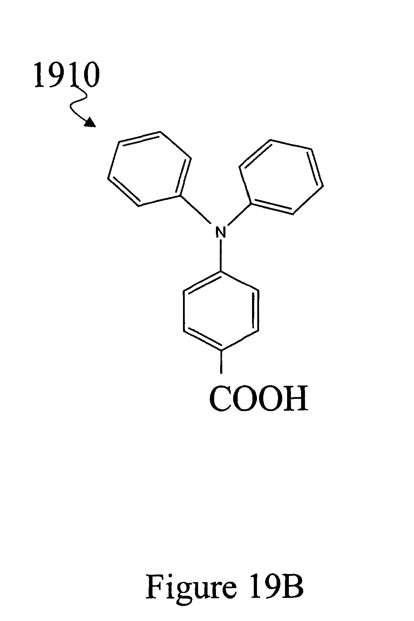

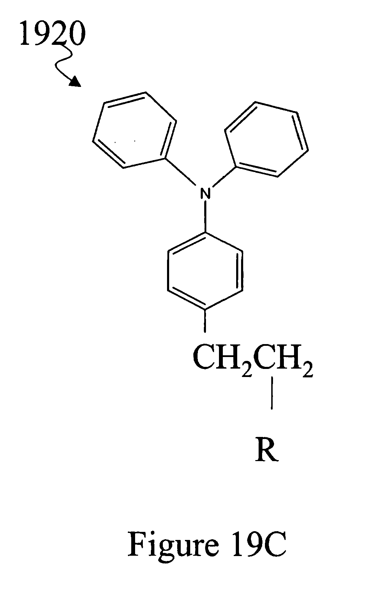

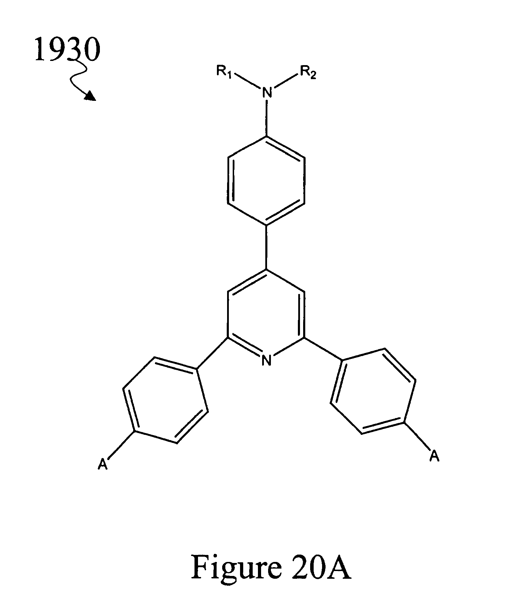

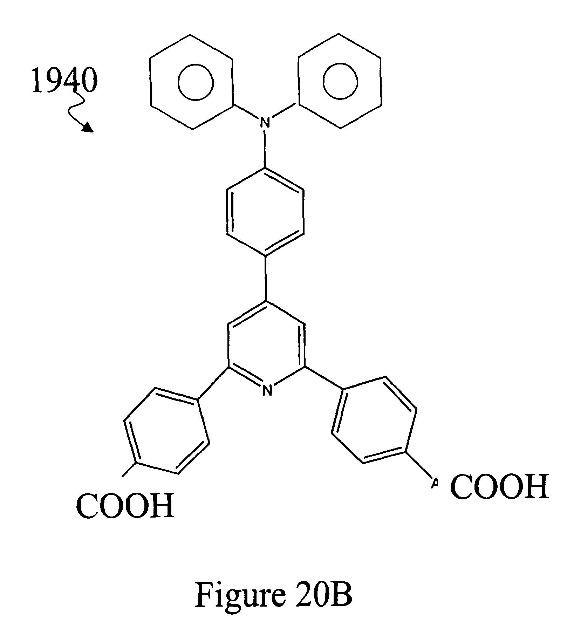

In particular, it was discovered that aromatic amines enhance cell performance of dye sensitized titania solar cells if the concentration of the co-sensitizer is below about 50 mol% of the dye concentration. An example of the general molecular structure of the preferred aromatic amines is shown in Figures 19 and 20. Preferably, the concentration of the co-sensitizer is in the range of about 1 mol% to about 20 mol%, and more preferably in the range of about 1 mol% to about 5 mol%.

Figure 19A depicts a chemical structure **1900** that may serve as a co-sensitizer. The molecule 1900 adsorbs to the surface of a nanoparticle layer via its coordinating group or chelating group, A. A may be a carboxylic acid group or derivative thereof, a phosphate group, an oxime or an alpha ketoenolate, as described above. Figure 19B depicts a specific embodiment **1910** of the structure **1900,** namely DPABA (diphenylaminobenzoic acid), where A = COOH. Figure 19C depicts another specific amine **1920** referred to as DEAPA (N', N-diphenylaminophenylpropionic acid), with A as the carboxy derivative COOH.

Figure 20A shows a chemical structure **1930** that may serve as either a co-sensitizer, or a sensitizing dye. The molecule does not absorb radiation above 500 nm, and adsorbs to a surface of the nanoparticle layer via its coordinating or chelating groups, A. A may be a carboxylic acid group or derivative thereof, a phosphate group, an oxime or an alpha ketoenolate. R₁ and R₂ may each be a phenyl, alkyl, substituted phenyl, or benzyl group. Preferably, the alkyl may contain between 1 and 10 carbons. Figure 20B depicts a specific embodiment **1940** of the structure 1930, namely DPACA (2,6 bis (4-benzoicacid)-4-(4-N,N-diphenylamino) phenylpyridine carboxylic acid), where R₁ and R₂ are phenyl and A is COOH.

DPACA **1940** may be synthesized as follows. 1.49 g (9.08 mmol) of 4-acetylbenzoic acid, 1.69 g (6.18 mmol) of 4-N,N- diphenylbenzaldehyde, and 5.8 g (75.2 mmol) of ammonium acetate were added to 60 ml of acetic acid in a 100 ml round bottom flask equipped with a condenser and stirring bar. The solution was heated to reflux with stirring under nitrogen for 5 hours. The reaction was cooled to room temperature and poured into 150 ml of water, which was extracted with 150 ml of dichloromethane. The dichloromethane was separated and evaporated with a rotary evaporator, resulting in a yellow oil. The oil was then eluted on a silica gel column with 4% methanol/dichloromethane to give the product, an orange solid. The solid was washed with methanol and vacuum dried to give 0.920 g of DPACA. The melting point was 199°-200 °C, the λₘₐₓ was 421 nm, and the molar extinction coefficient, E was 39,200 L mole⁻¹ cm⁻¹. The structure was confirmed by NMR spectroscopyThe solar cells characteristics listed include η, V_{oc}, I_{sc}, FF, Vₘ, and Iₘ. The ratios of sensitizer to co-sensitizer are based on the concentrations of photosensitizing agents in the sensitizing solution.

Table 12 shows the results for high-temperature-sintered titania; photosensitized by overnight soaking in solutions of 1 mM N3 dye and three concentrations of DPABA. Table 12 also shows that the average η is greatest for the preferred 20/1 (dye/co-sensitizer) ratio.

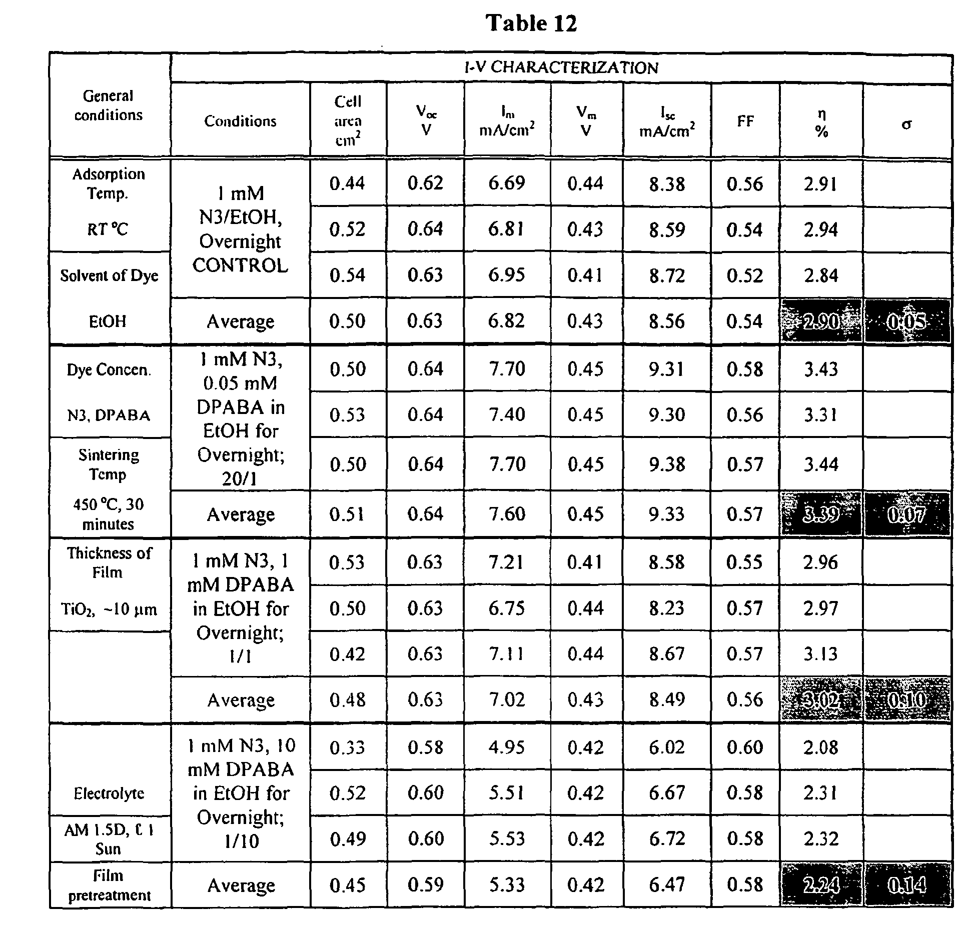

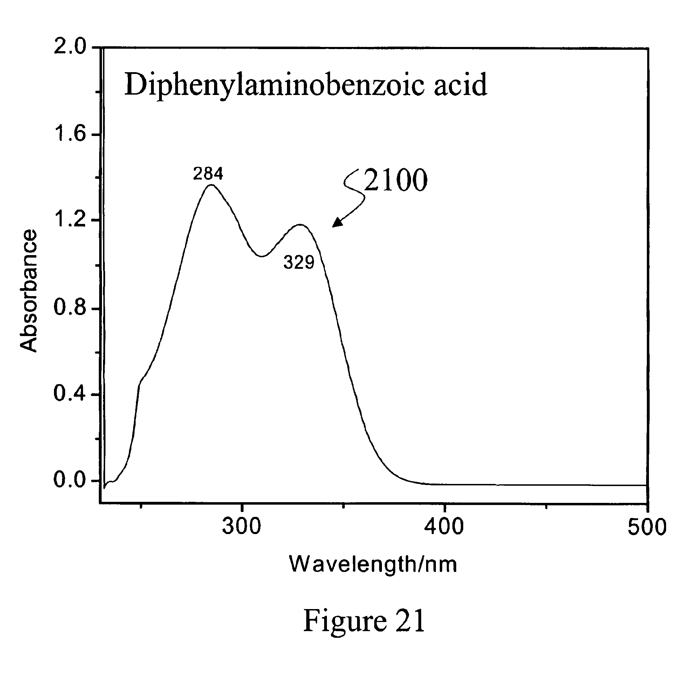

Table 13 shows the results of using a cut-off filter (third and fourth entries) while irradiating a cell to test its I-V characteristics. Table 13 also shows that the efficiency of the cell still improves when DPABA is present, indicating that its effect when no filter is present is not simply due to absorption of UV light by DPABA followed by charge injection. Figure 21 shows a plot **2100** of the absorbance versus wavelength for DPABA, which absorbs below 400 nm. Because the absorbance of the cut-off filter is large, little light reaches the absorption bands of DPABA.

**Table 13**

| Conditions | I-V CHARACTERIZATION | | | | | | | |
|---|---|---|---|---|---|---|---|---|
| | Cell area cm² | V_{oc} V | Iₘ mA/cm² | Vₘ V | I_{sc} mA/cm² | FF | η % | σ |
| 1 mM N3 in EtOH Overnight control | 0.49 | 0.70 | 8.62 | 0.46 | 11.02 | 0.51 | 3.97 | |
| | 0.49 | 0.70 | 8.13 | 0.45 | 10.20 | 0.51 | 3.66 | |
| | 0.49 | 0.73 | 7.93 | 0.51 | 9.69 | 0.57 | 4.04 | |
| Average | 0.49 | 0.71 | 8.23 | 0.47 | 10.30 | 0.53 | **3.89** | **0.20** |
| 1mM N3 0.05mM DPABA in EtOH, 20/1 Overnight | 0.49 | 0.71 | 9.05 | 0.46 | 11.53 | 0.51 | 4.16 | |
| | 0.49 | 0.71 | 9.24 | 0.46 | 11.56 | 0.52 | 4.25 | |
| | 0.49 | 0.71 | 9.39 | 0.46 | 11.50 | 0.53 | 4.32 | |
| Average | 0.49 | 0.71 | 9.23 | 0.46 | 11.53 | 0.52 | **4.24** | **0.08** |
| 1 mM N3 in EtOH Overnight control | 0.49 | 0.69 | 6.35 | 0.47 | 7.83 | 0.55 | 4.26 | 455nm cut off filter used, 70 mW/cm² |
| | 0.49 | 0.69 | 6.05 | 0.46 | 7.44 | 0.54 | 3.98 | |
| | 0.49 | 0.72 | 5.74 | 0.52 | 6.94 | 0.60 | 4.27 | |
| Average | 0.49 | 0.70 | 6.05 | 0.48 | 7.40 | 0.56 | **4.17** | **0.17** |
| 1mM N3 0.05mM DPABA in EtOH, 20/1 Overnight | 0.49 | 0.70 | 6.73 | 0.47 | 8.21 | 0.55 | 4.52 | 455nm cut off filter used, 70 mW/cm² |
| | 0.49 | 0.70 | 6.74 | 0.47 | 8.19 | 0.55 | 4.53 | |
| | 0.49 | 0.70 | 6.74 | 0.49 | 8.25 | 0.57 | 4.72 | |
| Average | 0.49 | 0.70 | 6.74 | 0.48 | 8.22 | 0.56 | **4.59** | **0.11** |

Table 14 shows that the addition of triphenylamine itself (i.e., no titania complexing groups such as carboxy) does not significantly enhance efficiency under the stated conditions.

**Table 14**

| Conditions | I-V CHARACTERIZATION | | | | | | | |
|---|---|---|---|---|---|---|---|---|
| | Cell area cm² | V_{oc} V | **I**ₘ mA/cm² | Vₘ V | I_{sc} mA/cm² | FF | η % | σ |
| 0.5 mM N3 in EtOH, Overnight | 0.49 | 0.70 | 7.96 | 0.45 | 9.82 | 0.52 | 3.58 | |
| | 0.49 | 0.71 | 8.09 | 0.48 | 9.58 | 0.57 | 3.88 | |
| | 0.49 | 0.70 | 7.47 | 0.48 | 8.83 | 0.58 | 3.59 | |
| Average | 0.49 | 0.70 | 7.84 | 0.47 | 9.41 | 0.56 | **3.68** | **0.17** |
| 0.5 mM N3, 0.025 mM TPA in EtOH Overnight 20/1 | 0.49 | 0.69 | 7.44 | 0.45 | 9.21 | 0.53 | 3.35 | |
| | 0.49 | 0.69 | 7.61 | 0.47 | 9.75 | 0.53 | 3.58 | |
| | 0.49 | 0.69 | 6.98 | 0.45 | 8.56 | 0.53 | 3.14 | |
| Average | 0.49 | 0.69 | 7.34 | 0.46 | 9.17 | 0.53 | **3.36** | **0.22** |
| 0.5 mM N3, 2.0 mM TPA in EtOH Overnight ¼ | 0.49 | 0.68 | 4.62 | 0.44 | 5.66 | 0.53 | 2.03 | |
| | 0.49 | 0.66 | 4.18 | 0.45 | 5.38 | 0.53 | 1.88 | |
| | 0.49 | 0.66 | 4.51 | 0.45 | 5.82 | 0.53 | 2.03 | |
| Average | 0.49 | 0.67 | 4.44 | 0.45 | 5.62 | 0.53 | **1.98** | **0.09** |

Table 15 shows that the effect is present using low temperature interconnected titania and that the 20/1 (dye/co-sensitizer) ratio is preferred.

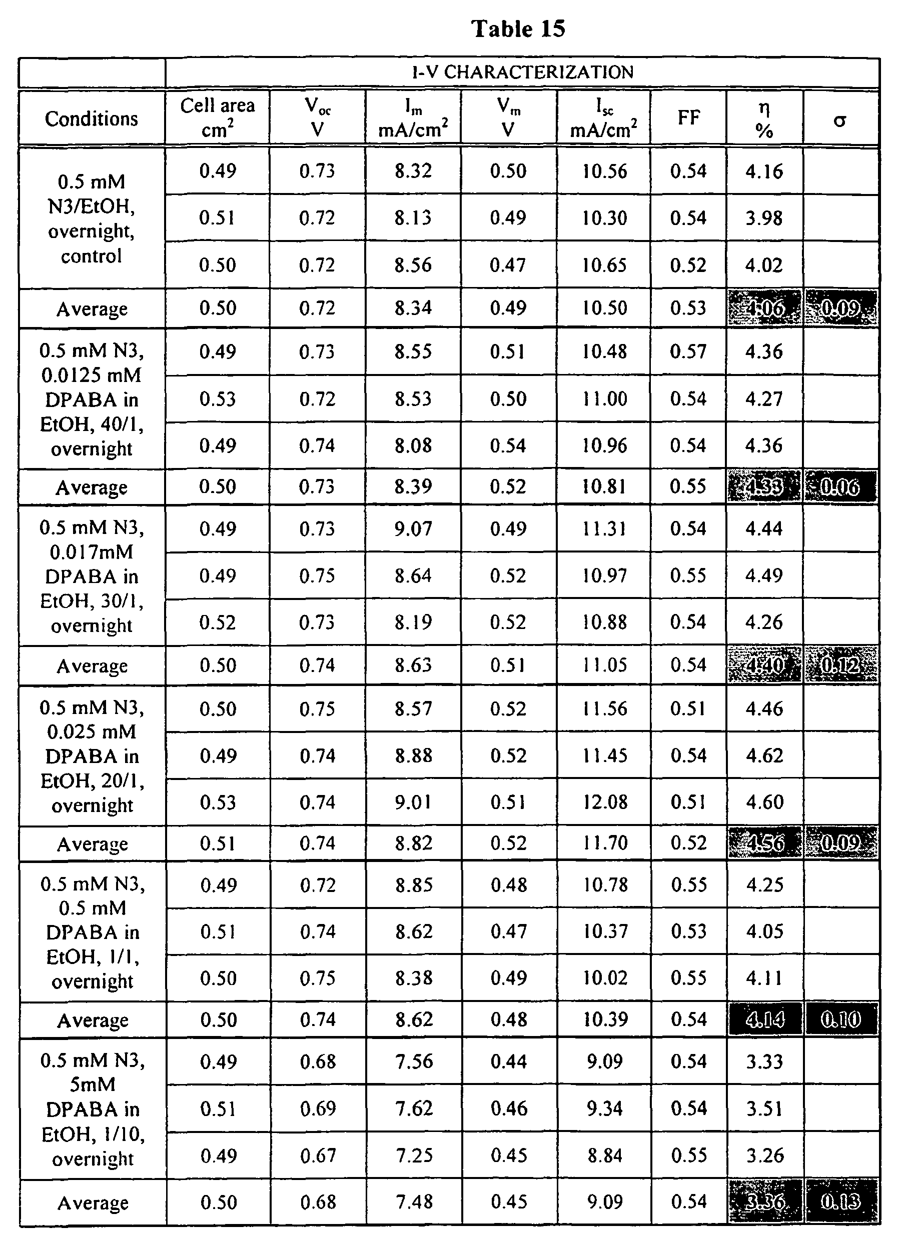

Table 16 shows results for high-temperature-sintered titania sensitized with a high concentration of N3 dye while maintaining a 20/1 ratio of dye to co-sensitizer. Entries 1 and 2 show the increase in cell performance due to co-sensitizer. Entry 3 shows the effect of DPABA alone as a sensitizer, demonstrating that this material acts as a sensitizer by itself when irradiated with the full solar spectrum, which includes low-intensity UV radiation.

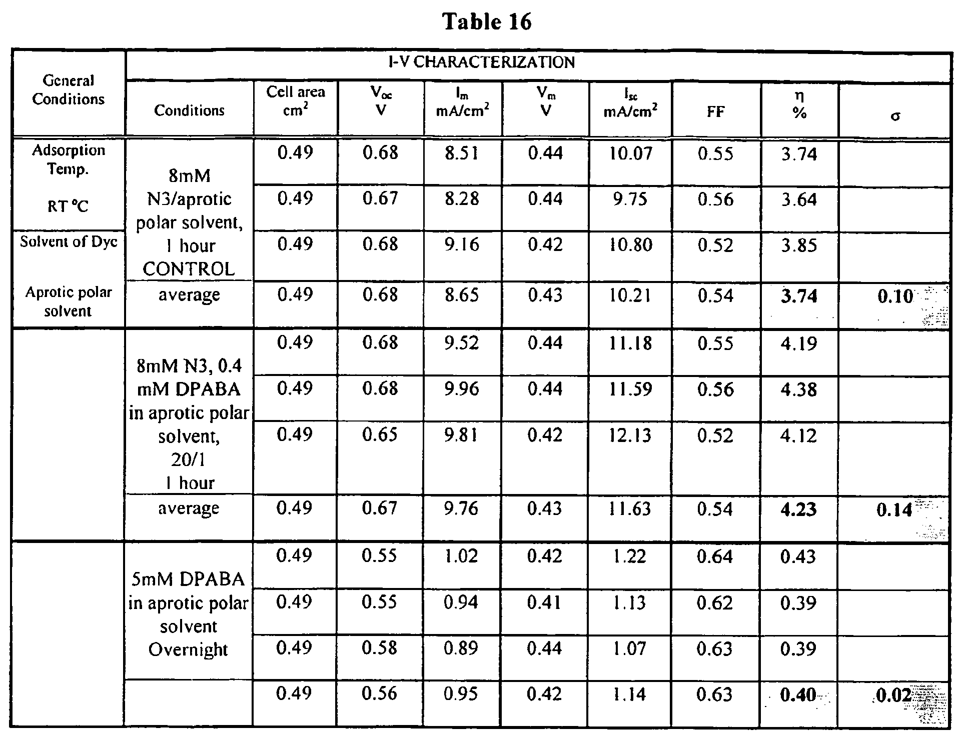

Table 17 shows results for low-temperature-interconnected titania. Entry 5 shows the affect of DPACA alone as a sensitizer, demonstrating that this material acts as a sensitizer by itself when irradiated with the full solar spectrum, which includes low-intensity UV radiation.

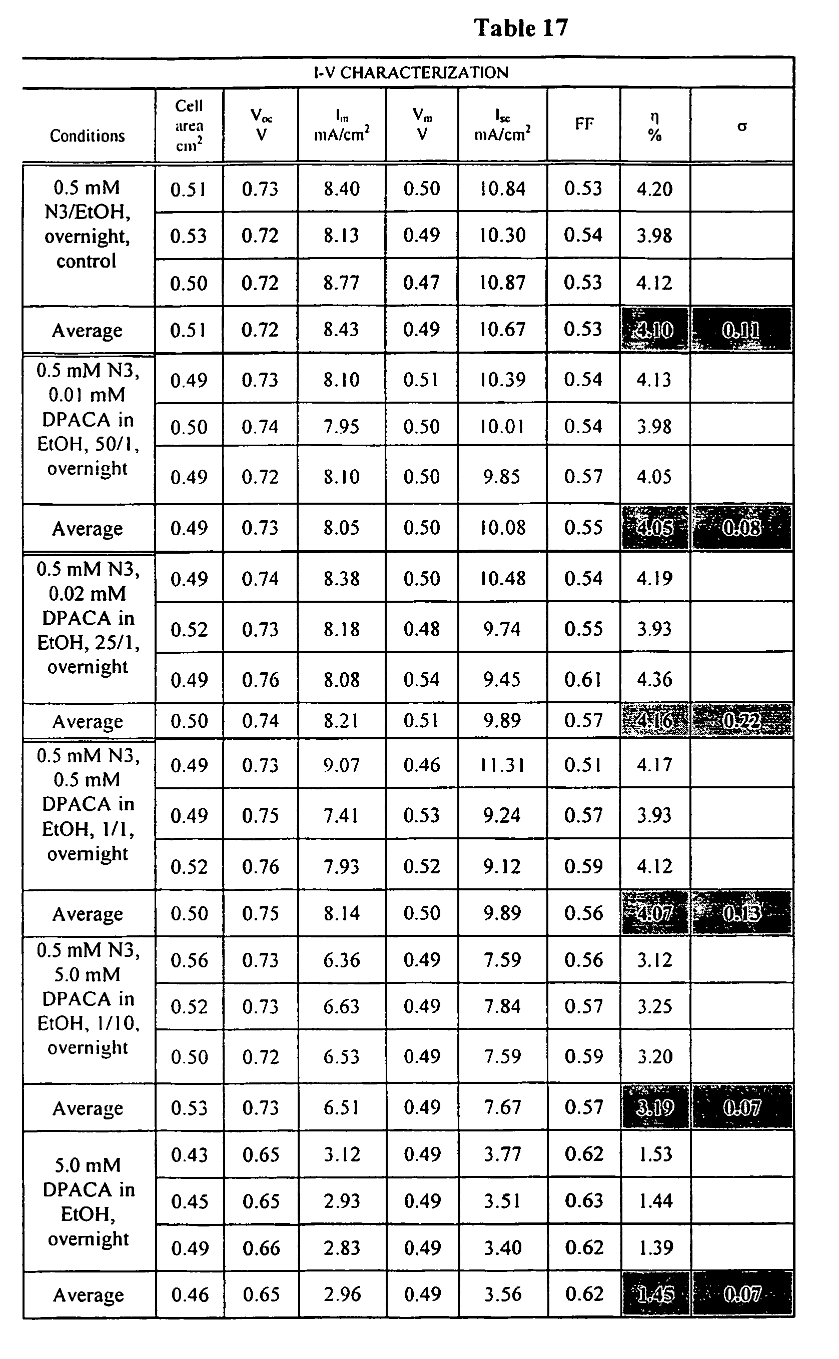

Table 18 shows results for low-temperature-interconnected titania. Entry 6 shows the affect of DEAPA alone as a sensitizer, demonstrating that this material acts as a sensitizer by itself when irradiated with the full solar spectrum, which includes low-intensity UV radiation.

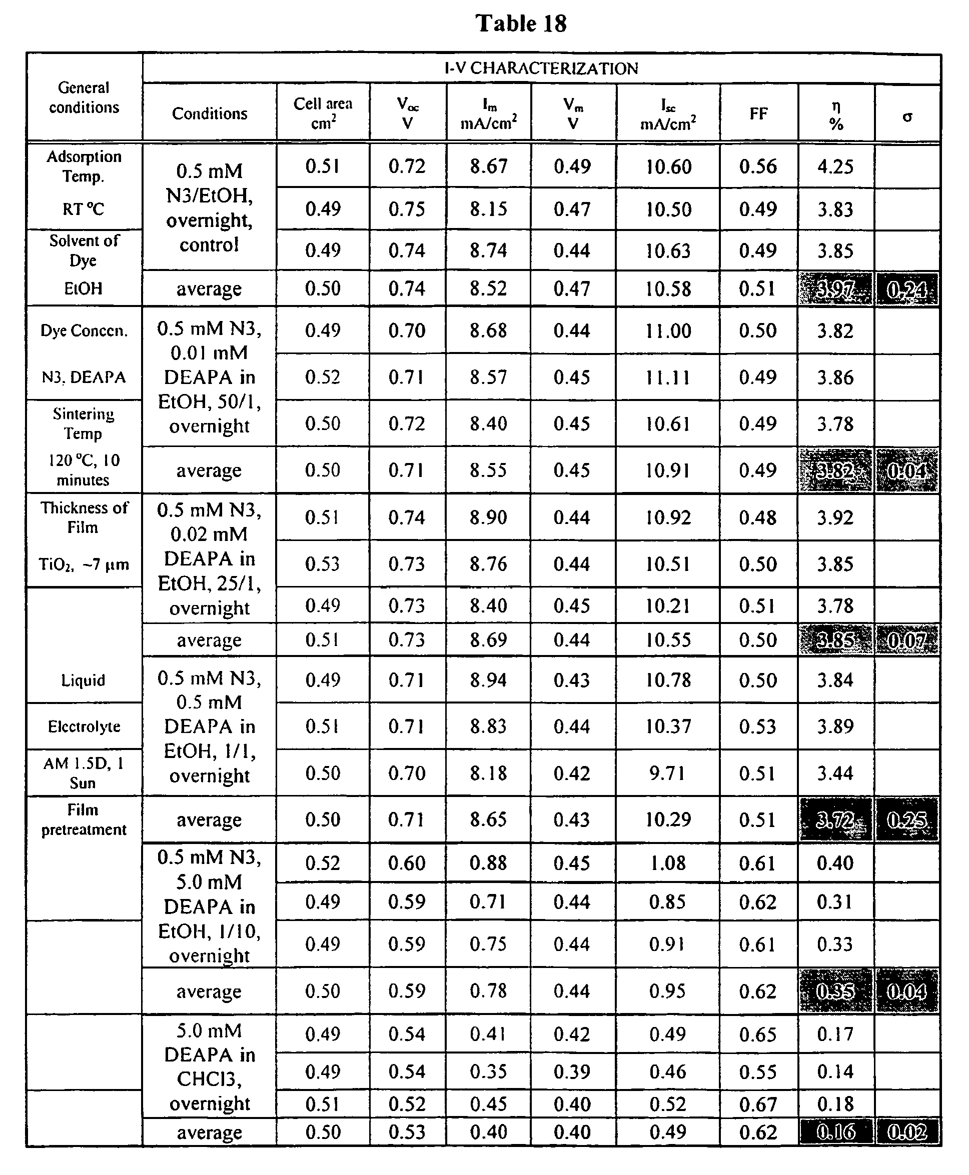

### E. Semiconductor Oxide Formulations

In a further illustrative example, there is provided semiconductor oxide formulations for use with DSSCs formed using a low temperature semiconductor oxide nanoparticle interconnection, as described above. The semiconductor oxide formulations may be coated at room temperature and, upon drying at temperatures between about 50 °C and about 150 °C, yield mechanically stable semiconductor nanoparticle films with good adhesion to the transparent conducting oxide (TCO) coated plastic substrates. In one example, the nanoparticle semiconductor of the photosensitized interconnected nanoparticle material **112, 212, 312,** and **412** is formed from a dispersion of commercially available TiO₂ nanoparticles in water, a polymer binder, with or without acetic acid. The polymer binders used include, but are not limited to, polyvinylpyrrolidone (PVP), polyethylene oxide (PEO), hydroxyethyl cellulose (HOEC), hydroxypropyl cellulose, polyvinyl alcohol (PVA) and other water-soluble polymers. The ratio of semiconductor oxide particles, e.g., TiO₂, to polymer can be between about 100:0. 1 to 100:20 by weight, and preferably is between about 100:1 to 100:10 by weight. The presence of acetic acid in the formulation helps to improve the adhesion of the coating to the TCO coated substrate. However, acetic acid is not essential and semiconductor oxide dispersions without acetic acid perform satisfactorily. In another example, the TiO₂ nanoparticles are dispersed in an organic solvent, such as, e.g., isopropyl alcohol, with polymeric binders such as, e.g., PVP, butvar, ethylcellulose, etc.

In another illustrative example, the mechanical integrity of the semiconductor oxide coatings and the photovoltaic performance of the dye sensitized cells based on these coatings can be further improved by using a crosslinking agent to interconnect the semiconductor nanoparticles. The polylinkers described above may be used for this purpose. These crosslinking agents can be applied, e.g., in the titania coating formulation directly or in a step subsequent to drying the titania coating as a solution in an organic solvent such as ethanol, isopropanol or butanol. For example, subsequent heating of the films to temperatures in the range of about 70 °C to about 140 °C leads to the formation of TiO₂ bridges between the TiO₂ nanoparticles. Preferably, the concentration of the polylinkers in this example ranges from about 0.01 to about 20 weight % based on titania.

### F. Semiconductor Primer Layer Coatings

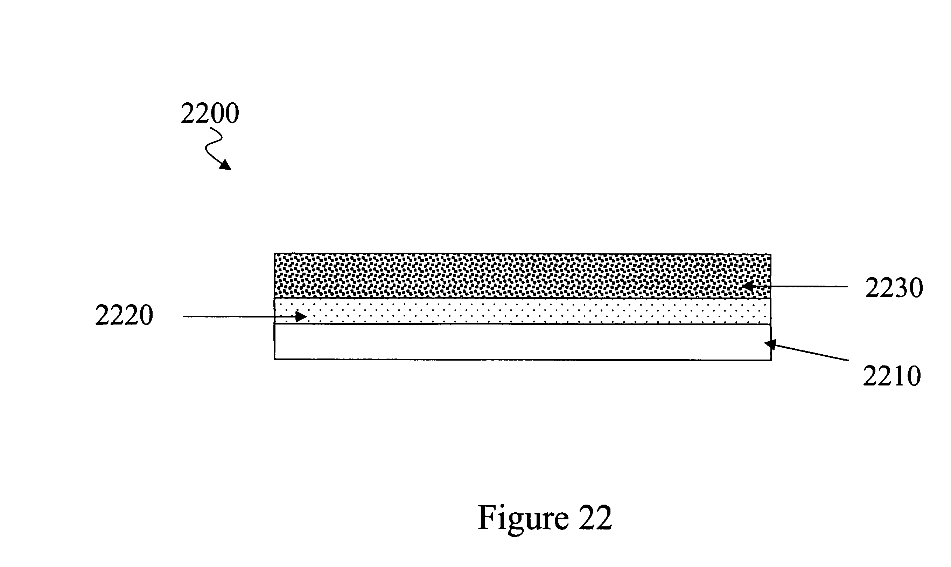

In another illustrative example, there are provided semiconductor oxide materials and methods of coating semiconductor oxide nanoparticle layers on a base material to form DSSCs. Figure 22 depicts an illustrative example **2200** of the coating process.

In this illustrative example, a base material **2210** is coated with a first primer layer **2220** of a semiconductor oxide, and then a suspension of nanoparticles **2230** of the semiconductor oxide is coated over the primer layer **2220.** The primer layer 2220 may include a vacuum-coated semiconductor oxide film (e.g., a TiO₂ film). Alternatively, the primer layer **2220** may include a thin coating with fine particles of a semiconductor oxide (e.g. TiO₂, SnO₂). The primer layer **2220** may also include a thin layer of a polylinker or precursor solution, one example of which is the titanium (IV) butoxide polymer **1500** shown in Figure 15 above. According to one illustrative example, the base material **2210** is the electrically conductive fiber core **102** or **202** or the inner electrical conductor **304** or **404** shown in Figures 1-4. Additionally, the base material **2210** is a transparent, conducting, plastic substrate. According to this illustrative example, the suspension of nanoparticles **2230** is the photosensitized interconnected nanoparticle material **112, 212, 312,** and **412** of Figures 1-4. Numerous semiconducting metal oxides, including SnO₂, TiO₂, Ta₂O₅, Nb₂O₅, and ZnO, among others, in the form of thin films, fine particles, or precursor solutions may be used as primer layer coatings using vacuum coating, spin coating, blade coating or other coating methods.

The primer layer **2220** improves the adhesion of nano-structured semiconductor oxide films, like layer **2230,** to the base material **2210.** Enhancements in the performance of DSSCs with such primer layers have been observed and will be described below. The enhancement arises from an increase in the adhesion between the semiconductor oxide nanoparticles (or photoelectrodes) and the transparent conducting oxide coated plastic substrates, as well as from higher shunt resistance.

Examples of various illustrative examples, in the context of a DSSC including a titanium dioxide nanoparticle layer, are as follows.

### Example 18. Vacuum Coated TiO₂ as Prime Layers for Nanoparticle TiO₂ Photoelectrodes

In this illustrative example, thin TiO₂ films with thicknesses ranging from 2.5 nm to 100 nm were sputter-coated under vacuum on an ITO layer coated on a polyester (here, PET) substrate. A water based TiO₂ (P25, with an average particle size of 21 nm) slurry was spin-coated on both the ITO/PET with sputter-coated thin TiO₂ and on the plain ITO/PET (i.e., the portion without sputter-coated thin TiO₂). The coated films were soaked in poly [Ti(OBu)₄] solution in butanol and then heat treated at 120 °C for 2 minutes. The low- temperature reactively interconnected films were placed into an aprotic, polar solvent-based N3 dye solution (8 mM) for 2 minutes. Photovoltaic cells were made with platinum (Pt) counter-electrodes, an I' /I₃' liquid electrolyte, 2 mil SURLYN, and copper conducting tapes. I-V characterization measurements were performed with a solar simulator.

Adhesion of nanostructured TiO₂ films from the P25 slurry coated on the ITO/PET with sputter-coated, thin TiO₂ was superior to films on the plain ITO/PET. Better photovoltaic performance was also observed from the PV cells prepared on the ITO/PET with sputter-coated, thin TiO₂ as compared to those on the plain ITO/PET. Improvement on the fill-factor was achieved as well. A FF as high as 0.67 was measured for the photovoltaic cells made on the ITO/PETs with sputter-coated, thin TiO₂. For the photovoltaic cells made on the plain ITO/PET, the FF observed was not greater than 0.60. Higher photovoltaic conversion efficiencies (about 17 % higher than the photoelectrodes made from the plain ITO/PET) were measured for the photoelectrodes prepared on the ITO/PET with thin sputter-coated TiO₂. Improvement in shunt resistance was also observed for the photovoltaic cells made on the ITO/PET with thin sputter-coated TiO₂.

### Example 19. Fine Particles of TiO₂ as Primer Layer for TiO₂ Suspensions

In this illustrative example, fine particles of TiO₂, small enough such that they would stick in the valleys between spikes of ITO on the PET substrate, were prepared by hydrolyzing titanium (IV) isopropoxide. The fine particles were then spin coated at 800 rpm onto the ITO layer. A 37% TiO₂ (P25) suspension of approximately 21 nm average particle size was then spin coated at 800 rpm onto the fine particle layer. The coated TiO₂ was low temperature interconnected by dipping in 0.01 molar Ti (IV) butoxide polymer in butanol for 15 minutes followed drying on a slide warmer at 50 °C before heating at 120 °C for 2 minutes. The interconnected coating was dyed with N3 dye by dipping into an 8 mM aprotic polar solvent solution for 2 minutes, then rinsed with ethanol and dried on a slide warmer at 50 °C for 2 minutes. Control coatings were prepared in the same way, except without the fine particle prime coat. The cells' performance characteristics were measured using a solar simulator. Results for test and control are listed below in Table 19. Fine particles of tin oxide as primer coating for TiO₂ suspensions yielded similar improvements.

**Table 19**

| | V_{oc} | I_{sc} | η | FF |
|---|---|---|---|---|
| Control | 0.64 | 4.86 | 1.67% | 0.54 |
| Test | 0.66 | 6.27 | 2.36% | 0.57 |

### Example 20. Titanium (IV) Butoxide Polymer in Butanol (Precursor Solution) as Primer Layer for TiO₂

In another test, titanium (IV) butoxide polymer in butanol at 0.01 molar was spin coated on an ITO/PET plastic base at 800 rpm. A 43% TiO₂ (P25) suspension of approximately 21 nm average particle size was spin coated at 800 rpm. The coated TiO₂ was interconnected at low temperature by dipping in 0.01 M titanium (IV) butoxide polymer in butanol for 15 minutes and then drying on a slide warmer at 50 °C before heating at 120 °C for 2 minutes. The sintered coating was dyed with N3 dye by dipping into an 8 mM aprotic, polar solvent solution for 2 minutes, then rinsed with ethanol and dried on a slide warmer at 50 °C for 2 minutes. Control coatings were prepared in the same way only without the primer layer coating. The I-V properties of the cells were measured with a solar simulator. Results for test and control are listed below in Table 20.

**Table 20**

| | V_{oc} | I_{sc} | η | FF |
|---|---|---|---|---|
| Control | 0.66 | 7.17 | 2.62% | 0.56 |
| Test | 0.70 | 8.11 | 3.38% | 0.59 |

### Example #21 Photovoltaic fiber

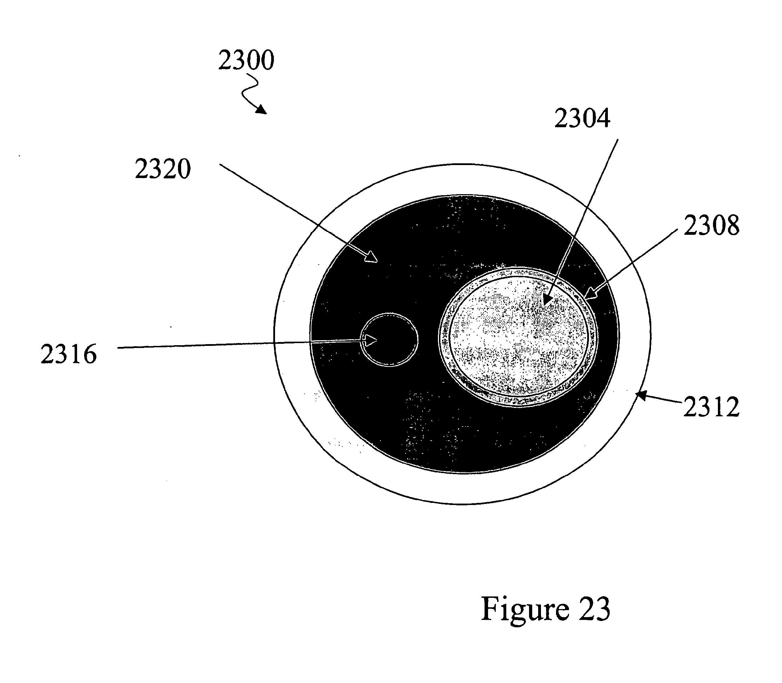

Figure 23 depicts an exemplary photovoltaic fiber 2300 according to the invention. A titanium wire **2304**, cleaned in a mixture of hydrofluoric and nitric acids resulting in a micro-grained surface, was coated with a dispersion of TiO₂ nanoparticles **2308** (isopropanol-based, 34.9% solids, to which 1 part in 480 of a 0.073% polybutoxytitanate solution in butanol was added). The dispersion was applied to the titanium wire **2304** using a tapered glass applicator of approximately 10 milli inches ("mil") orifice diameter. To improve the integrity of the TiO₂ coating **2308** and the ability to handle the coated wire, the TiO₂ coating **2308** was sintered at relatively high temperatures (about 450 °C) for 30 minutes. The TiO₂ coating **2308** was dye sensitized by immersion in an 8 mM N3-dye solution for two minutes at room temperature, dipping in ethanol for 45 seconds, and air-drying. The titanium wire **2304** with the TiO₂ coating **2308** was inserted into a protective layer **2312**, which was a TEFLON (available from DuPont) micro-tubing (available from Zeus Industrial Products). A fine platinum wire was also inserted into the protective layer 2312 to serve as the counter electrode **2316.** The protective layer **2312** was filled with a liquid electrolyte **2320** to complete the photovoltaic fiber **2300.**

A typical dry coverage of TiO₂ **2308** on the titanium wire **2304** was 10 mil. The diameter of the titanium wire **2304** was 7.7 mil. The TEFLON micro-tubing protective layer **2312** was 16 mil, although 20 mil tubing also can be used. The platinum wire counter electrode **2316** was 3 mil in diameter. The liquid electrolyte **2320** was a solution of 1 M LiI, 0.05 M iodine, and 1 M *t-*butylpyridine in methoxypropionitrile. The photovoltaic characteristics were measured in a solar simulator. The range of open circuit voltage, V_{oc} was 0.70 V to 0.73 V, and the range of short circuit current, I_{sc} was 4.1 mA/cm² to 4.6 mA/cm². The solar efficiency for a typical cell was 1.53%. Photovoltaic fibers that were fabricated with anodized titanium wires had an average solar efficiency of 2.11%.

The protective layer **2312** is not limited to TEFLON. The protective layer may be any flexible, light-transmissive polymeric material including, but not limited to, mylar polyacrylates, polystyrenes, polyureas, polyurethane, epoxies, and the like. The protective layer **2312** may be coated on the photovoltaic fiber **2300,** rather than inserting the elements into the protective layer **2312.** Coating methods include, but are not limited to, spraying, dispersing, or dipping the fiber into a protective material to form the protective layer **2312.**

## Claims

1. A photovoltaic fiber comprising:
a fiber core (502) having an outer surface;
a photosensitized nanomatrix material applied to the outer surface of the fiber core (502);
a protective layer (524), therein disposed the photosensitized nanomatrix material coated fiber core (502), a charge carrier material (515), and a counter electrode (504),
**characterized in that**
the counter electrode (504) is formed of one or more wires (504) that are imbedded in a significantly light transmitting electrical conductor (506) or that may also be partially imbedded in the charge carrier material (515).

2. The photovoltaic fiber of claim 1, wherein the fiber core (502) is substantially electrically conductive.

3. The photovoltaic fiber of claim 1, wherein the fiber core (502) is substantially electrically insulative and further comprises an inner electrical conductor being disposed on the electrically insulative fiber core (502).

4. The photovoltaic fiber of claim 1, wherein the protective layer (524) comprises a flexible polymeric material.

5. The photovoltaic fiber of claim 1, wherein the photosensitized nanomatrix material includes nanoparticles or a heterojunction composite material.

6. The photovoltaic fiber of claim 5, wherein the heterojunction composite material comprises fullerenes, fullerene particles and/or carbon nanotubes.

7. The photovoltaic fiber of claim 5, wherein the heterojunction composite material comprises a conjugated polymer and/or a composite of conjugated polymers.

8. The photovoltaic fiber of claim 5, herein the heterojunction composite material comprises composites including polythiophene, and polyquinoline composites of polyphenylene vinylene, in conjunction with non-polymeric material.

9. The photovoltaic fiber of one of claims 1 to 8, wherein the counter electrode (504) comprises platinum, copper, silver, gold, nickel, palladium, iron or alloys thereof.

10. A method of forming a photovoltaic fiber, the method comprising the steps of:
providing a fiber core (502) having an outer surface;
applying a photosensitized nanomatrix material to the outer surface of the fiber core (502); and
disposing the photosensitized nanomatrix material coated fiber core (502), a charge carrier material (515), and a counter electrode (504) within a protective layer (524) to form a photovoltaic fiber,
**characterized in that**
the counter electrode (504) is formed of one or more wires (504) that are imbedded in a significantly light transmitting electrical conductor (506) or that may also be partially imbedded in the charge carrier material (515).

11. The method of claim 10, wherein the fiber core (502) is substantially electrically conductive.

12. The method of claim 10, wherein the fiber core (502) comprises an is substantially electrically insulative and further comprises an inner electrical conductor being disposed on the electrically insulative fiber core (502).

13. The method of claim 10, wherein the protective layer (524) comprises a flexible polymeric material.

14. The method of claim 10, wherein the photosensitized nanomatrix material includes nanoparticles or a heterojunction composite material.

15. The method of claim 14, wherein the heterojunction composite material comprises fullerenes, fullerene particles and/or carbon nanotubes.

16. The method of claim 14, wherein the heterojunction composite material comprises a conjugated polymer and/or a composite of conjugated polymers.

17. The method of claim 14, herein the heterojunction composite material comprises composites including polythiophene, and polyquinoline or composites of polyphenylene vinylene, in conjunction with non-polymeric material.

18. The method of one of claims 10 to 17, wherein the counter electrode (504) comprises platinum, copper, silver, gold, nickel, palladium, iron or alloys thereof.

19. The method of claim 10, wherein disposing step comprises inserting the photosensitized nanomatrix material coated fiber core (502), the charge carrier material, and the counter electrode (504) into the protective layer (524) to form the photovoltaic fiber.

20. The method of claim 10, wherein disposing step comprises coating the protective layer (524) over the photosensitized nanomatrix material coated fiber core (502), the charge carrier material, and the counter electrode (504) to form the photovoltaic fiber.

## Patentansprüche

1. Photovoltaische Faser umfassend:
ein Faserkern (502), der eine äußere Oberfläche hat;
ein lichtempfindlich gemachtes Nanomatrixmaterial aufgebracht auf die äußere Oberfläche des Faserkerns (502);
eine Schutzschicht (524), darin angeordnet der mit dem lichtempfindlich gemachten Nanomatrixmaterial beschichtete Faserkern (502), ein Ladungsträgermaterial (515), und eine Gegenelektrode (504),
**gekennzeichnet dadurch, dass**
die Gegenelektrode (504) wird aus einem oder mehreren Drähten (504) gebildet, die in einem erheblich lichttransmittierenden elektrischen Leiter (506) eingebettet sind, oder die auch teilweise eingebettet sein können in das Ladungsträgermaterial (515).

2. Photovoltaische Faser gemäß Anspruch 1, wobei der Faserkern (502) im Wesentlichen elektrisch leitfähig ist.

3. Photovoltaische Faser gemäß Anspruch 1, wobei der Faserkern (502) im wesentlichen elektrisch isolierend ist und weiter einen inneren elektrischen Leiter umfasst, der an den elektrisch isolierenden Faserkern (502) angeordnet ist ist.

4. Photovoltaische Faser gemäß Anspruch 1, wobei die Schutzschicht (524) ein flexibles polymerisches Material umfasst.

5. Photovoltaische Faser gemäß Anspruch 1, wobei das lichtempfindlich gemachte Nanomatrixmaterial Nanopartikel oder ein Heteroübergang-Mischmaterial beinhaltet.

6. Photovoltaische Faser gemäß Anspruch 5, wobei das Heteroübergang-Mischmaterial Fullerene, Fullerenpartikel und Kohlenstoffnanoröhrchen umfasst.

7. Photovoltaische Faser gemäß Anspruch 5, wobei das Heteroübergang-Mischmaterial ein konjugiertes Polymer und/oder eine Mischung von konjugierten Polymeren umfasst.

8. Photovoltaische Faser gemäß Anspruch 5, wobei das Heteroübergang-Mischmaterial Mischungen beinhaltend Polythiophene und Polyquinoline oder Mischungen aus Polyphenylvinylen, in Zusammenhang mit nichtpolymerischen Materialien umfastt.

9. Photovoltaische Faser gemäß einem der Ansprüche 1 bis 8, wobei die Gegenelektrode (504) Platin, Kupfer, Silber, Gold, Nickel, Palladium, Eisen oder Legierungen aus diesen umfasst.

10. Verfahren zum Bilden einer photovoltaischen Faser, wobei das Verfahren umfasst die Schritte von:
bereitstellen eines Faserkerns (502), der eine äußere Oberfläche hat;
aufbringen eines lichtempfindlich gemachten Nanomatrixmaterials auf die äußere Oberfläche des Faserkerns (502); und
anordnen des mit dem lichtempfindlichen Nanomatrixmaterial beschichteten Faserkerns (502), eines Ladungsträgermaterials (515), und
einer Gegenelektrode (504) in einer Schutzschicht (524), um eine photovoltaische Faser zu bilden,
**gekennzeichnet dadurch, dass**
die Gegenelektrode (504) aus einem oder mehreren Drähten (504) gebildet wird, die in einem erheblich lichttransmittierenden elektrischen Leiter (506) eingebettet sind, oder die auch teilweise in dem Ladungsträgermaterial (515) eingebettet sein können.

11. Verfahren gemäß Anspruch 10, wobei der Faserkern (502) im Wesentlichen elektrisch leitfähig ist.

12. Verfahren gemäß Anspruch 10, wobei der Faserkern (502) im Wesentlichen elektrisch isolierend ist und weiter einen inneren elektrischen Leiter umfasst, der an den elektrisch isolierenden Faserkern (502) angeordnet ist.

13. Verfahren gemäß Anspruch 10, wobei die Schutzschicht (524) ein flexibles polymerisches Material umfasst.

14. Verfahren gemäß Anspruch 10, wobei das lichtempfindlich gemachte Nanomatrixmaterial Nanopartikel oder ein Heteroübergang-Mischmaterial beinhaltet.

15. Verfahren gemäß Anspruch 14, wobei das Heteroübergang-Mischmaterial Fullerene, Fullerenpartikel und oder Kohlenstoffnanoröhrchen umfasst.

16. Verfahren gemäß Anspruch 14, wobei das Heteroübergang-Mischmaterial ein konjugiertes Polymer oder eine Mischung von konjugierten Polymeren umfasst.

17. Verfahren gemäß Anspruch 14, wobei das Heteroübergang-Mischmaterial Polythiophen und Polyquinolin oder eine Mischung von Polyphenylvinylen, in Verbindung mit nicht-polymerisches Material umfasst.

18. Verfahren gemäß einem der Ansprüche 10 bis17, wobei die Gegenelektrode (504) Platin, Kupfer, Silber, Gold, Nickel, Palladium, Eisen, oder Legierung daraus umfasst.

19. Verfahren gemäß Anspruch 10, wobei der Schritt des Anordnens beschichten des mit photoempfindlich gemachten Nanomatrixmaterial beschichteten Faserkerns (502), des Ladungsträgermaterials, und der Gegenelektrode (504) in die Schutzschicht (524) umfasst, um eine photovoltaische Faser zu bilden.

20. Verfahren gemäß Anspruch 10, wobei der Schritt des Anordnens beschichten der Schutzschicht (524) über den mit photoempfindlich gemachten Nanomatrixmaterial beschichteten Faserkern (502), dem Ladungsträgermaterial, und der Gegenelektrode (504) umfasst, um die photovoltaische Faser zu bilden.

## Revendications

1. Fibre photovoltaïque comportant :
un noyau de fibre (502) ayant une surface externe ;
un matériau à nanomatrice photosensibilisé appliqué à la surface externe du noyau de fibre (502) ;
une couche protectrice (524), dans laquelle est disposé le noyau de fibre (502) revêtu du matériau à nanomatrice photosensibilisé, et une contre électrode (504), un matériau porteur de charges (515), et une contre électrode (504)
**caractérisée en ce que**
la contre électrode (504) est formée d'un ou plusieurs fils (504) qui sont noyés dans un conducteur électrique (506) transmettant la lumière de manière importante ou qui peuvent aussi être partiellement noyés dans le matériau porteur de charges (515).

2. Fibre photovoltaïque selon la revendication 1, dans laquelle le noyau de fibre (502) est sensiblement conducteur de l'électricité.

3. Fibre photovoltaïque selon la revendication 1, dans laquelle le noyau de fibre (502) est sensiblement isolant de l'électricité et comporte de plus un conducteur électrique interne disposé sur le noyau de fibre (502) isolant de l'électricité.

4. Fibre photovoltaïque selon la revendication 1, dans laquelle la couche protectrice (524) comporte un matériau polymère souple.

5. Fibre photovoltaïque selon la revendication 1, dans laquelle le matériau à nanomatrice photosensibilisé comporte des nanoparticules ou un matériau composite à hétérojonction.

6. Fibre photovoltaïque selon la revendication 5, dans laquelle le matériau composite à hétérojonction comporte des fullerènes, des particules de fullerène et/ou des nanotubes de carbone.

7. Fibre photovoltaïque selon la revendication 5, dans laquelle le matériau composite à hétérojonction comporte un polymère conjugué et/ou un composite de polymères conjugués.

8. Fibre photovoltaïque selon la revendication 5, dans laquelle le matériau composite à hétérojonction comporte des composites comportant du polythiophène, et de la polyquinoline ou des composites de polyphénylène vinylène, en conjonction avec un matériau non polymère.

9. Fibre photovoltaïque selon l'une quelconque des revendications 1 à 8, dans laquelle la contre électrode (504) comporte du platine, du cuivre, ou de l'argent, ou de l'or, ou du nickel, ou du palladium, ou de l'acier ou des alliages de ceux-ci.

10. Procédé de fabrication d'une fibre photovoltaïque, le procédé comportant les étapes consistant à :
fournir un noyau de fibre (502) ayant une surface externe ;
appliquer un matériau à nanomatrice photosensibilisé à la surface externe du noyau de fibre (502) ; et
disposer le noyau de fibre revêtu du matériau à nanomatrice photosensibilisé, un matériau porteur de charges (515), et une contre électrode (504) à l'intérieur d'une couche protectrice (504) pour former me fibre photovoltaïque,
**caractérisé en ce que** la contre électrode (504) est formée d'un ou plusieurs fils (504) qui sont noyés dans un conducteur électrique (506) transmettant la lumière de manière importante ou qui peuvent aussi être partiellement noyés dans le matériau porteur de charges (515).

11. Procédé selon la revendication 10, dans lequel le noyau de fibre (502) est sensiblement conducteur de l'électricité.

12. Procédé selon la revendication 10, dans lequel le noyau de fibre (502) est sensiblement isolant de l'électricité et comporte de plus un conducteur électrique interne disposé sur le noyau de fibre (502) sensiblement isolant de l'électricité.

13. Procédé selon la revendication 10, dans lequel la couche protectrice (524) comporte un matériau polymère souple.

14. Procédé selon la revendication 10, dans lequel le matériau à nanomatrice photosensibilisé est un matériau à composite à hétérojonction.

15. Procédé selon la revendication 14, dans lequel le matériau composite à hétérojonction comporte des fullerènes, des particules de fullerène et/ou des nanotubes de carbone.

16. Procédé selon la revendication 14, dans lequel le matériau composite à hétérojonction comporte un polymère conjugué et/ou un composite de polymères conjugués.

17. Procédé selon la revendication 14, dans lequel le matériau composite à hétérojonction comporte des composites comportant du polythiophène, et de la polyquinoline ou des composites de polyphénylène vinylène, en conjonction avec un matériau non polymère.

18. Procédé selon l'une quelconque des revendications 10 à 17, dans lequel la contre électrode (504) comporte du platine, du cuivre, ou de l'argent, ou de l'or, ou du nickel, ou du palladium, ou de l'acier ou des alliages de ceux-ci.

19. Procédé selon la revendication 10, dans lequel l'étape de disposition comporte une étape d'insertion du noyau de fibre (502) revêtu du matériau à nanomatrice photosensibilisé, du matériau porteur de charges et de la contre électrode (504) dans la couche protectrice (524) pour former une fibre photovoltaïque.

20. Procédé selon la revendication 10, dans lequel l'étape de disposition comporte une étape consistant à revêtir la couche protectrice (524) sur le noyau de fibre (502) revêtu du matériau à nanomatrice photosensibilisé, le matériau porteur de charges et la contre électrode (504) pour former la fibre photovoltaïque.
